(19) Europäisches Patentamt
European Patent Office
Office européen des brevets

(11) EP 2 832 792 A1

(12) **EUROPEAN PATENT APPLICATION**
published in accordance with Art. 153(4) EPC

(43) Date of publication:
**04.02.2015 Bulletin 2015/06**

(21) Application number: **13767287.9**

(22) Date of filing: **28.03.2013**

(51) Int Cl.:
***C08L 63/00*** *(2006.01)* ***C08K 3/28*** *(2006.01)*
***C08K 5/52*** *(2006.01)* ***H01L 23/12*** *(2006.01)*
***H01L 23/36*** *(2006.01)*

(86) International application number:
**PCT/JP2013/059384**

(87) International publication number:
**WO 2013/147086 (03.10.2013 Gazette 2013/40)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **30.03.2012 JP 2012081300**

(71) Applicant: **Tokuyama Corporation**
**Shunan-shi, Yamaguchi-ken 745-8648 (JP)**

(72) Inventor: **OHNO, Hideki**
**Shunan-shi**
**Yamaguchi 745-8648 (JP)**

(74) Representative: **Beck Greener**
**Fulwood House**
**12 Fulwood Place**
**London WC1V 6HR (GB)**

(54) **CURABLE RESIN COMPOSITION, METHOD FOR PRODUCING SAME, HIGHLY THERMALLY CONDUCTIVE RESIN COMPOSITION, AND HIGHLY THERMALLY CONDUCTIVE MULTILAYER SUBSTRATE**

(57) A curable resin composition including aluminum nitride particles, an epoxy resin, a curing agent and an acidic phosphate ester represented by the following formula (1):

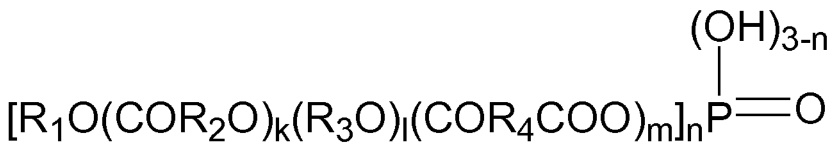

(1)

(In the formula (1),
$R_1$ represents a C4-20 hydrocarbyl group;
$R_2$ represents a C1-20 saturated hydrocarbylene group;
$R_3$ represents a C2-3 saturated hydrocarbylene group;
$R_4$ represents a C1-8 hydrocarbylene group;
k represents an integer of 0 to 20;1 represents an integer of 0 to 20;
m represents an integer of 0 to 20; and
n represents an integer of 1 or 2, wherein
where a plurality of $R_i$ (i is 1 to 4) exist, the plurality of $R_i$ may be the same as or different from each other;
k $-COR_2O-$ groups, 1 $-R_3O-$ groups, and m $-COR_4COO-$ groups may be in any order; and
where n is 2, two $R_1O(COR_2O)_k(R_3O)_l(COR_4COO)_m$ groups may be the same as or different from each other.)

EP 2 832 792 A1

Fig. 6

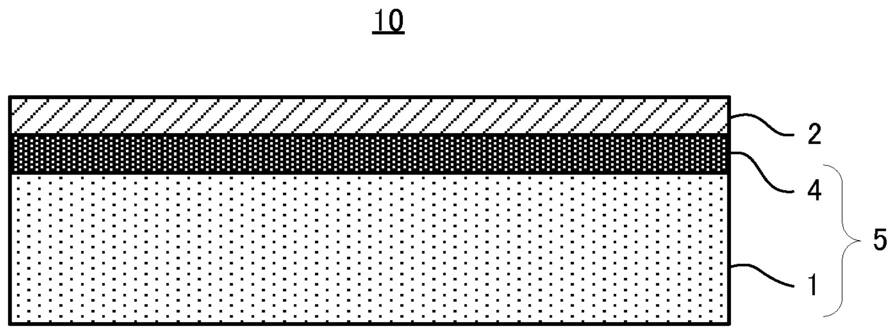

## Description

BACKGROUND OF THE INVENTION

Field of the Invention

The present invention relates to a high thermal conductive resin composition used for heat dissipation of electronic materials.

Description of the Related Art

A semiconductor device called a power semiconductor is used for transformation and modulation of a power supply of an electronic device. The power density of a power device provided with the power semiconductor has been rapidly increased with a demand for downsizing and high efficiency of the electronic device. On the other hand, the temperature of the device needs to be kept no more than a predetermined temperature for the sake of a stable operation and lifetime of the device, thus the efficient release of the heat generated by the device is important. For the heat dissipation of a high-power device such as a device having an output power of 1 kW or more, a metalized ceramics substrate including an insulating ceramics substrate having a high thermal conductivity, such as aluminum nitride, silicon nitride, and alumina, and a metal wiring such as copper wiring formed on the insulating ceramics substrate, is generally used.

In order to join a metal to the metalized ceramics substrate, an alloy called a solder typified by a silver solder has been conventionally used. Such a joining method includes: printing a circuit on a ceramics substrate by means of a paste composition including the solder and a binder; thereafter heating the substrate at a temperature no less than the melting point of the solder; thereby strongly joining the ceramics and the metal together (Patent Document 1). Besides, in a case where a higher accuracy is needed, a method of: applying the solder to the whole surface of a ceramics substrate; thereafter forming a metal layer of copper or the like by means of plating or bonding; followed by etching the metal layer (Patent Document 2) has been generally employed. However, these methods have drawbacks such that they require a high raw material cost since silver is used in the solder, and that they also require a high energy cost for manufacturing since the melting point of the solder is usually 600°C or more, and that in a case where the metal layer is thick, due to the difference between the ceramics and the metal in thermal expansion coefficient, separation can occur between the ceramics and the metal in a severe heat cycle test.

On the other hand, nowadays, the application of an LED device has been rapidly expanding with the improvement in brightness of the LED device. Specifically in a case where an LED device having a high brightness is employed, a circuit substrate is required to have a high heat dissipation performance as well. The power semiconductor mentioned above normally has an output power of several hundred Watts or more and there are some power semiconductors having an output power of 1 kW or more. In contrast, the maximum output power of the LED device is around several hundred Watts. Therefore, required characteristics are different between the circuit substrate for power semiconductor and the circuit substrate for LED device. That is, since the power devices are generally operated at a hundred and several tens °C under their using conditions, a circuit substrate for power semiconductor is required to have adhesive strength to bear a heat cycle having a temperature range from a high temperature as described to a room temperature, or below the freezing point. On the other hand, since the lifetime of the LED devices is strongly affected by the operation temperature, the circuit for LED device needs to have a good heat dissipation performance so as to make the operation temperature of the device as low as possible. Since the operation temperature of the LED is normally 100°C or less, not so severe condition is imposed to the adhesive strength between the ceramics and the metal in the circuit substrate for LED devices as required for the substrate which mounts a power semiconductor having a high output power. In manufacturing the circuit substrate for LED devices, for example, a method of: forming an adhesive layer by means of evaporating or spattering a metal such as titanium on an insulating substrate of aluminum nitride or the like; thereafter forming a conductive layer of nickel, metal or the like on the adhesive layer by means of plating, sputtering or evaporating, is employed (Patent Document 3). However, it is important to reduce the manufacturing cost so as to make the LEDs become widespread for real. Therefore cost reduction is required across all of components and manufacturing processes.

As a low cost joining method capable of obtaining a necessary and sufficient adhesive strength between the ceramics and the metal in the circuit substrate for LED device, adhesion by a resin-base material such as an epoxy resin can be given. However, when a present epoxy resin is employed for the adhesion application as above, it is difficult to increase thermal conductivity as a whole metalized ceramics substrate, since the thermal conductivity of the adhesive layer is insufficient. Furthermore, an attempt to improve the thermal conductivity of the epoxy resin adhesive layer by adding a high thermal conductive filler such as alumina, boron nitride, aluminum nitride and the like has been intensively studied in recent days. However, even if the filler as above is added to the adhesive layer, the adhesive layer has not obtained a sufficient thermal conductivity yet.

On the other hand, for an application which does not necessarily require a high heat dissipation performance as above, for instance, for an LED for a back light of a liquid crystal display television, for an LED for illumination having a low output power and the like, heat dissipation is generally carried out by means of a substrate having a large area whose thermal conductivity is not so high. For the substrate, a metal based substrate, especially an aluminum based substrate which employs aluminum for the metal has been used. The aluminum based substrate is a laminated substrate including a metal foil for forming a circuit, an organic inorganic composite resin as an insulting layer, and an aluminum substrate. However, since the thermal conductivity of the composite resin is insufficient at present, the thermal conductivity as a whole laminated substrate has not been increased. Therefore, in the aluminum based substrate as well, in a case where the aluminum based substrate is used for an application requiring a comparatively high output power, such as an LED for illumination, as a result of increasing in the temperature of the LED device, there is a possibility of causing problems such as decrease of luminous efficiency and lifetime. Therefore, it is needed to increase the thermal conductivity of the composite resin. However, an insulting resin having a high thermal conductivity bearing actual use which can be manufactured by easy and low cost processes has not been developed yet.

Moreover, in the field of electronic material, not only substrate materials described above, but also different insulting materials having different high thermal conductivities are required. Specifically, a heat curable high thermal conductive resin has a various use applications such as a semiconductor sealing material, an underfill to adhere a semiconductor device and a substrate, a die bonding material, and other adhesive agents. Meanwhile, as described above, since the demand level to the heat dissipation is rapidly increasing with demand for downsizing and high output power of semiconductor devices, the thermal conductivity of the heat curable high thermal conductive resin is required to improve further.

Generally, a thermal conductivity of a resin in which inorganic particles are filled rises with increase of the filler content of the inorganic particles, and the slope of the increasing curve has a larger slope as the resin has greater amount of the filled inorganic particles. Therefore, in order to obtain a resin having a high thermal conductivity, it is needed to disperse a large amount of inorganic particles having a high thermal conductivity in the resin, and to achieve this, the viscosity of the resin filled with the inorganic particles needs to be kept low. Conventionally, for this purpose, various techniques such as combining spherical particles having different particle diameters (Patent Document 4), or adding a solvent having a high boiling point (Patent Document 5) have been suggested. However, even though these techniques are applied to the epoxy resin, the effect is not sufficient.

Citation List

Patent Literatures

Patent Document 1: Japanese Patent Application Laid-Open No. H09-181423
Patent Document 2: Japanese Patent Application Laid-Open No. H10-284813
Patent Document 3: International Publication No. 2006/098454
Patent Document 4: Japanese Patent Application Laid-Open No. 2005-320479
Patent Document 5: Japanese Patent Application Laid-Open No. H10-173097


SUMMARY OF THE INVENTION

Problems to be Solved by the Invention

As described above, for the metalized ceramics substrate, a new joining method which realizes an adhesive layer having a necessary and sufficient adhesive strength between the ceramics and the metal together with a high thermal conductivity is required. In the metal based substrate as well, a composite resin having a high thermal conductivity capable of forming an insulting layer having a low heat resistance at low cost is required.

Accordingly, an object of the present invention is to provide a curable resin composition having a necessary and sufficient adhesive strength and capable of forming an insulting adhesive layer having a high thermal conductivity at low cost, and a method for manufacturing the curable resin composition. Also, the present invention provides a high thermal conductive resin composition, a high thermal conductive laminated substrate, and a method for manufacturing the high thermal conductive laminated substrate.

Means for Solving the Problems

A first aspect of the present invention is a curable resin composition comprising aluminum nitride particles, an

epoxy resin, a curing agent and an acidic phosphate ester represented by the following formula (1), wherein the aluminum nitride particles, the epoxy resin, the curing agent and the acidic phosphate ester are mixed with each other in the curable resin composition. In the first aspect of the present invention, the term "the aluminum nitride particles, the epoxy resin, the curing agent and the acidic phosphate ester are mixed with each other" can be reworded as "the aluminum nitride particles are dispersed in a mixture including the epoxy resin, the curing agent and the acidic phosphate ester represented by the following formula (1)".

[Formula 1]

$$[R_1O(COR_2O)_k(R_3O)_l(COR_4COO)_m]_nP(=O)(OH)_{3-n} \quad (1)$$

(In the formula (1),

$R_1$ represents a saturated or unsaturated hydrocarbyl group having a carbon number of 4 to 20;
$R_2$ represents a saturated hydrocarbylene group having a carbon number of 1 to 20;
$R_3$ represents a saturated hydrocarbylene group having a carbon number of 2 or 3;
$R_4$ represents a saturated or unsaturated hydrocarbylene group having a carbon number of 1 to 8;
k represents an integer of 0 to 20;
1 represents an integer of 0 to 20;
m represents an integer of 0 to 20; and
n represents an integer of 1 or 2, wherein
where a plurality of $R_1$ exist, the plurality of $R_1$ may be the same as or different from each other;
where a plurality of $R_2$ exist, the plurality of $R_2$ may be the same as or different from each other;
where a plurality of $R_3$ exist, the plurality of $R_3$ may be the same as or different from each other;
where a plurality of $R_4$ exist, the plurality of $R_4$ may be the same as or different from each other;
k-number of $-COR_2O-$ groups, 1-number of $-R_3O-$ groups, and m-number of $-COR_4COO-$ groups may be in any order; and
where n is 2, two $R_1O(COR_2O)_k(R_3O)_l(COR_4COO)_m$ groups may be the same as or different from each other.).

A second aspect of the present invention is a method for manufacturing a curable resin composition comprising the step of mixing aluminum nitride particles, an epoxy resin, a curing agent and an acidic phosphate ester represented by the above formula (1) with each other.

A third aspect of the present invention is a high thermal conductive resin composition, which is obtained by curing the curable resin composition according to the first aspect of the present invention.

The forth aspect of the present invention is a high thermal conductive laminated substrate comprising a metallic foil, the high thermal conductive resin composition according to the third aspect of the present invention and a metal or high thermal conductive ceramic substrate, wherein the metallic foil, the high thermal conductive resin composition and the metal or high thermal conductive ceramic substrate are layered in the order mentioned.

The fifth aspect of the present invention is a method for manufacturing a high thermal conductive laminated substrate comprising the successive step of layering a metallic foil and a metal or high thermal conductive ceramic substrate, wherein the curable resin composition according to the first aspect of the present invention is disposed between the metallic foil and the metal or high thermal conductive ceramic substrate, and curing the curable resin composition.

Effects of the Invention

According to the first aspect of the present invention, it is possible to provide a curable resin composition capable of obtaining at low cost, by curing, a high thermal conductive resin composition having an improved adhesive strength and thermal conductivity. The curable resin composition may be preferably manufactured by the manufacturing method according to the second aspect of the present invention.

The curable resin composition according to the first aspect of the present invention and the high thermal conductive resin composition according to the third aspect of the present invention which can be obtained by curing the curable resin composition have a wide range of use application for electronic materials, and especially useful for obtaining an insulating adhesive layer of the high thermal conductive laminated substrate according to the fourth aspect of the present invention. Since the high thermal conductive laminated substrate according to the fourth aspect of the present invention can be manufactured at low cost and has an increased thermal conductivity, it may be preferably employed

as a circuit substrate for LED device and a circuit substrate for power semiconductor having a low output power. The high thermal conductive laminated substrate may be preferably manufactured by the manufacturing method according to the fifth aspect of the present invention.

BRIEF DESCRIPTION OF THE DRAWINGS

Fig. 1 is a flowchart to explain an embodiment S1 of the manufacturing method of the curable resin composition according to the second aspect of the present invention;
Fig. 2 is a flowchart to explain another embodiment S2 of the manufacturing method of the curable resin composition according to the second aspect of the present invention;
Fig. 3 is a flowchart to explain another embodiment S3 of the manufacturing method of the curable resin composition according to the second aspect of the present invention;
Fig. 4 is a flowchart to explain another embodiment S4 of the manufacturing method of the curable resin composition according to the second aspect of the present invention;
Fig. 5 is a cross-sectional view to schematically explain a state of the curable resin composition in the high thermal conductive laminated substrate according to the fourth aspect of the present invention before curing the curable resin composition;
Fig. 6 is a cross-sectional view to schematically explain the high thermal conductive laminated substrate according to the fourth aspect of the present invention;
Fig. 7 is a flowchart to explain one embodiment S10 of the manufacturing method of the high thermal conductive laminated substrate according to the fifth aspect of the present invention;
Fig. 8 is a flowchart to explain another embodiment S11 of the manufacturing method of the high thermal conductive laminated substrate according to the fifth aspect of the present invention;
Fig. 9 is a flowchart to explain another embodiment S12 of the manufacturing method of the high thermal conductive laminated substrate according to the fifth aspect of the present invention;
Fig. 10 is a flowchart to explain another embodiment S13 of the manufacturing method of the high thermal conductive laminated substrate according to the fifth aspect of the present invention.

DETAILED DESCRIPTION OF THE INVENTION

In the present specification, an expression "A to B" regarding numerical values A and B means "no less than A and no more than B", unless otherwise specified. In cases where the unit of the numerical value A is omitted in the expression, the unit given to the numerical value B is applied as the unit of the numerical value A.

Also, in the specification, "average particle size" means a sphere equivalent diameter (volume mean value D50) which gives the median of a volume distribution measured by LASER diffraction method. Measurement of a volume distribution of particles by LASER diffraction method can be preferably performed using Microtrack® manufactured by Nikkiso Co., Ltd.

<1. Curable resin composition>

The curable resin composition according to the first aspect of the present invention will be explained.

(Aluminum nitride particles)

As the aluminum nitride particles in the curable resin composition of the present invention, known aluminum nitride particles may be employed without particular limitations. Production method of the aluminum nitride particles is not particularly limited either, and the method may be nitridation method or may be carbothermal nitridation method. The average particle size of the aluminum nitride particles is not particularly limited, and for example aluminum nitride particles having an average particle size of 10 nm to 100 μm may be employed.

In one preferable embodiment, a mixture of aluminum nitride particles having different average particle sizes is used. For example, to the total amount of the aluminum nitride particles, by employing a mixture of 30 to 80 mass% of aluminum nitride particles having an average particle size of 10 to 100 μm, 10 to 60 mass% of aluminum nitride particles having an average particle size of 1 μm or more and no more than 10 μm, and 3 to 30 mass% of aluminum nitride particles having an average particle size of 100 nm or more and no more than 1 μm, the viscosity of the curable resin composition can be kept lower, whereby it is possible to further increase the filling amount of the aluminum nitride particles in the curable resin composition.

It should be noted that, in a case where a high water resistance is required for the high thermal conductive resin composition obtained by curing the curable resin composition, it is preferable that the average particle size of the aluminum nitride particles is 100 nm to 100 μm.

As a preferable example of a case where an especially high water resistance is required for the high thermal resin composition which can be obtained by curing the curable resin composition of the present invention, an embodiment in which water resistant aluminum nitride particles obtained by performing in advance a water resistance treatment to aluminum nitride particles are mixed with an epoxy resin and the like can be given. As a treatment agent for the water resistance treatment (hereinafter sometimes referred to as a "water resistance treatment agent" for short), phosphoric acids, metal phosphate salts such as aluminum phosphate, acidic phosphate esters, phosphonic acid compounds, silane coupling agents, organic acids and the like can be exemplified. One water resistance treatment agent may be used alone, or two or more water resistance treatment agent may be used in combination. Among the water resistance treatment agents exemplified above, one or more selected from phosphoric acids, metal phosphate salts such as aluminum phosphate, and acidic phosphate esters can be preferably employed. Among them, when the water resistance treatment is performed using acidic phosphate esters, it is possible to obtain a particularly good water resistance, and it becomes easy to further increase the thermal conductivity of the high thermal conductive resin composition which can be obtained by curing the curable resin composition. The acidic phosphate esters used for the water resistance treatment of the aluminum nitride particles do not have to satisfy the condition of the acidic phosphate ester (above general formula (1)) which is an essential component of the curable resin composition of the present invention.

In carrying out the water resistance treatment to the aluminum nitride particles, a known method can be employed without particular limitations. For example, a method of: mixing aluminum nitride particles and a water resistance treatment agent in a solvent (i.e. wet process) or without solvent (i.e. dry process); thereafter forming a coating on the surface of each of the aluminum nitride particles by a heat treatment, is normally employed. In order to improve the thermal conductivity and the water resistance at the same time, it is desirable to form a uniform and thin coating, thus it is preferable to carry out a treatment by means of the water resistance treatment agent to the aluminum nitride particles dispersed in a solvent. As the solvent for the water resistance treatment, for example, a solvent in which the water resistance treatment agent dissolves may be selected from: water; alcohols such as methanol and ethanol; esters such as ethyl acetate; ketones such as acetone and ethyl methyl ketone; ethers such as diethyl ether and tert-butyl methyl ether, and the like.

Ceramic particles other than the aluminum nitride particles may be contained in the curable resin composition of the present invention, if needed. In an embodiment of the curable resin composition of the present invention in which ceramic particles other than the aluminum nitride particles are further contained, the aluminum nitride particles, the ceramic particles other than the aluminum nitride particles, the epoxy resin, the curing agent and the acidic phosphate ester represented by the above general formula (1) are mixed with each other. In other words, the aluminum nitride particles and the ceramic particles other than the aluminum nitride particles are dispersed in a mixture including the epoxy resin, the curing agent and the acidic phosphate ester represented by the above general formula (1). As the ceramic particles other than the aluminum nitride particles which can be used in the curable resin composition of the present invention, alumina particles, magnesia particles, zinc oxide particles, silica particles, silicon nitride particles, boron nitride particles, silicon carbide particles and the like can be exemplified. Single ceramic particles other than the aluminum nitride particles may be used alone, or two or more of ceramic particles other than the aluminum nitride particles may be used in combination. A preferable range of the average particle size of the ceramics particles other than the aluminum nitride particles is not particularly limited, as well as the aluminum nitride particles explained above. For example, particles having an average particle size of 10 nm to 100 μm can be employed, and when a high water resistance is required, particles having an average particle size of 100 nm to 100 μm can be preferably employed.

In one preferable embodiment, a mixture of ceramics particles having different average particle sizes is employed. It should be noted that, in the present specification, the "ceramics particles" is a concept encompassing aluminum nitride particles, unless specified as "other than the aluminum nitride particles". For example, when a mixture of particles including, to the total amount of the ceramics particles, (1) 30 to 80 mass% of ceramics particles having an average particle size of 10 to 100 μm, (2) 10 to 60 mass% of ceramics particle having an average particle size of 1 μm to 10 μm, and (3) 3 to 30 mass% of ceramics particles having an average particle size of 100 nm to 1 μm (wherein one or more of the ceramic particles (1), (2) and (3) contain aluminum nitride particles) is employed, the viscosity of the curable resin composition can be kept lower, whereby it is possible to further increase the filling amount of the ceramics particles in the curable resin composition.

In view of increasing the thermal conductivity of the high thermal conductive resin composition which can be obtained by curing the curable resin composition of the present invention, the content of particles of alumina, magnesia, or zinc oxide is preferably such that the total surface area of these particles is no more than twice as much as the total surface area of the aluminum nitride particles, and more preferably such that the total surface area of these particles is no more than that of the aluminum nitride particles. Since silica has a low thermal conductivity, the amount of silica particles is preferably such that the total surface area of the silica particles is no more than the total surface area of

aluminum nitride particles, and more preferably half or less. Since silicon nitride and silicon carbide have high thermal conductivities, the content of particles of silicon nitride and silicon carbide is preferably such that the total surface area of these particles is no more than four times as much as the total surface area of the aluminum nitride particles, and more preferably three times or less. In a case where boron nitride particles are employed, since the thermal conductivity can be increased with increase of the content whereas the viscosity of the composition is increased, the content of the boron nitride particles is preferably such that the total surface area of the boron nitride particles is no more than four times as much as the total surface area of aluminum nitride particles.

In the present specification, the "total surface area" of particles means a value obtained by multiplying the specific surface area ($m^2/g$) of the particles measured by BET method (BET specific surface area) by the total mass (g) of the particles.

(Epoxy resin)

As the epoxy resin in the curable resin composition of the present invention, a known epoxy resin can be employed without any particular limitations. Specific examples thereof include: bisphenol A type or bisphenol F type epoxy resin, multifunctional epoxy resins such as a phenol novolac type epoxy resin and cresol novolac type epoxy resin, epoxy resins obtained by adding the multifunctional epoxy resin to the bisphenol A type or the bisphenol F type epoxy resin.

(Curing agent)

As the curing agent in the curable resin composition of the present invention, a known curing agent for a curing agent of epoxy resin can be employed without particular limitations. Specific examples thereof include: amines; polyamides; imidazoles; acid anhydrides; boron trifluoride amine complexes called latent curing agents; dicyandiamides; organic acid hydrazides; compounds having two or more phenolic hydroxy groups in one molecule such as phenol novolac resin, bisphenol novolac resin; and photo curing agents such as diphenyliodonium hexafluorophosphate, triphenylsulfonium hexafluorophosphate. Among them, amines, imidazoles and acid anhydrides are preferred.

Specific examples of the above amines include: chain aliphatic polyamines such as diethylenetriamine, triethylenetetramine, tetraethylenepentamine, dipropylenetriamine, and diethylaminopropylamine; cycloaliphatic polyamines such as N-(aminoethyl)piperazine and isophoronediamine; aromatic aliphatic amines such as m-xylenediamine; aromatic amines such as m-phenylenediamine, diaminodiphenylmethane, and diaminodiphenylsulfone.

Specific examples of the above imidazoles include: 2-methylimidazole, 2-ethyl-4-methylimidazole, 1-cyanoethyl-2-undecyl imidazolium trimellitate, epoxy-imidazole adduct.

Specific examples of the above acid anhydrides include: phthalic anhydride, trimellitic anhydride, pyromellitic anhydride, benzophenonetetracarboxylic anhydride, ethylene glycol bis(trimellitic anhydride), maleic anhydride, tetrahydrophthalic anhydride, methyltetrahydrophthalic anhydride, methyl endo-methylene-tetrahydrophthalic anhydride, methylbutenyltetrahydrophthalic anhydride, dodecenylsuccinic anhydride, hexahydrophthalic anhydride, succinic anhydride, methylcyclohexene dicarboxylic anhydride, alkylstyrene-maleic anhydride copolymer, chlorendic anhydride, poly(azelaic anhydride).

(Acidic phosphate ester)

The Acidic phosphate ester in the curable resin composition of the present invention has a structure represented by the following general formula (1).

[Chemical Formula 2]

$$[R_1O(COR_2O)_k(R_3O)_l(COR_4COO)_m]_nP(=O)(OH)_{3-n} \quad (1)$$

(In the formula (1),

$R_1$ represents a saturated or unsaturated hydrocarbyl group having a carbon number of 4 to 20;
$R_2$ represents a saturated hydrocarbylene group having a carbon number of 1 to 20;
$R_3$ represents a saturated hydrocarbylene group having a carbon number of 2 or 3;
$R_4$ represents a saturated or unsaturated hydrocarbylene group having a carbon number of 1 to 8;

k represents an integer of 0 to 20; 1 represents an integer of 0 to 20;
m represents an integer of 0 to 20; and
n represents an integer of 1 or 2, wherein
where a plurality of $R_1$ exist, the plurality of $R_1$ may be the same as or different from each other;
where a plurality of $R_2$ exist, the plurality of $R_2$ may be the same as or different from each other;
where a plurality of $R_3$ exist, the plurality of $R_3$ may be the same as or different from each other;
where a plurality of $R_4$ exist, the plurality of $R_4$ may be the same as or different from each other;
k-number of $-COR_2O-$ groups, 1-number of $-R_3O-$ groups, and m-number of $-COR_4COO-$ groups may be in any order; and
where n is 2, two $R_1O(COR_2O)_k(R_3O)_l(COR_4COO)_m$ groups may be the same as or different from each other.).

In the formula (1), $R_1$ is not particularly limited as long as it is a saturated or unsaturated hydrocarbyl group having a carbon number of 4 to 20. Specific examples of $R_1$ include: saturated hydrocarbyl groups such as octyl group, 2-ethylhexyl group, nonyl group, decyl group, undecyl group, dodecyl group, tetradecyl group, hexadecyl group, and octadecyl group; and unsaturated hydrocarbyl groups such as phenyl group and nonylphenyl group. The carbon number of $R_1$ is preferably 6 to 18. Especially where k=l=m=0, the carbon number of $R_1$ is preferably 10 to 18.

In the formula (1), $R_2$ is a saturated hydrocarbylene group having a carbon number of 1 to 20. The carbon number of $R_2$ is preferably 1 to 16. Specific examples of $R_2$ include: methylene group, ethylene group, penthylene group, tetradecylene group, pentadecylene group.

In the formula (1), $R_3$ is a saturated hydrocarbylene group having a carbon number of 2 or 3. The carbon number of $R_3$ is preferably 2, and more preferably $R_3$ is an ethylene group.

In the formula (1), $R_4$ is a saturated or unsaturated hydrocarbylene group having a carbon number of 1 to 8. The carbon number of $R_4$ is preferably 1 to 6. Specific examples of $R_4$ include: saturated hydrocarbylene groups such as methylene group, ethylene group, propylene group, butylene group, and pentylene group; and unsaturated hydrocarbylene group such as phenylene group.

In the formula (1), k is not particularly limited as long as k is an integer of 0 to 20. It is preferably an integer of 0 to 10.

In the formula (1), 1 is not particularly limited as long as 1 is an integer of 0 to 20. It is preferably an integer of 0 to 10.

In the formula (1), m is not particularly limited as long as m is an integer of 0 to 20. It is preferably an integer of 0 to 10.

In the formula (1), monomer units written with k, 1 and m, that is, k $-COR_2O-$ groups, l $-R_3O-$ groups and m $-COR_4COO-$ groups may be in any order between the $R_1O$-group and phosphorus atom. These groups do not have to be arranged in the literally same manner as in the formula (1). Also, - $(COR_2O)_k(R_3O)_l(COR_4COO)_m$-group may be a block copolymer or a random copolymer.

In the formula (1), n is 1 or 2. The acidic phosphate ester represented by the general formula (1) in the curable resin composition of the present invention needs one or more of acidic hydroxy group(s). Although the reason has not been clearly found out, the inventor presumes that it is because the aluminum nitride to be the filler is a solid base and an acid group is needed for adsorption to the surface of the aluminum nitride.

The acidic phosphate ester represented by the general formula (1) can be a mixture of a compound wherein n=1 and a compound wherein n=2. Also, where n=2 in the acidic phosphate ester represented by the general formula (1), the acidic phosphate ester may be a compound having different side chains in one molecule. That is, where n=2, two $R_1O(COR_2O)_k(R_3O)_l(COR_4COO)_m$ groups may be the same or different from each other. Further, the acidic phosphate ester represented by the above general formula (1) may be a mixture of compounds having different structures. The acidic phosphate ester represented by the general formula (1) generally can be obtained as a mixture of the compound wherein n=1 and the compound wherein n=2.

Use of acidic phosphate esters which are not the acidic phosphate ester represented by the general formula (1) may lead to increase in the viscosity or decrease in the thermal conductivity, since they do not have sufficient affinity to aluminum nitride and epoxy resin.

The molecular weight of the acidic phosphate ester represented by the general formula (1) is not particularly limited. It is preferably 5000 or less, more preferably 2000 or less, and most preferably 1500 or less. It is considered to be because the acidic phosphate ester having a shorter side chains absorbed on the surface of the aluminum nitride functions more advantageously to reduce the interface heat resistance between the aluminum nitride particles and the epoxy resin.

Commercially available specific examples of the above acidic phosphate esters include: DYSPERBYK-111 (manufactured by BYK-Chemie Japan), and BYK-W9010 (manufactured by BYK-Chemie Japan).

Among the acidic phosphate esters represented by the general formula (1), an acidic phosphate ester having a structure represented by the following general formula (2) (i.e. k=m=0) is preferable. Use of the acidic phosphate ester having such a structure makes it easy to further increase the thermal conductivity of the resin composition that is obtained by curing the curable resin composition of the present invention.

[Chemical Formula 3]

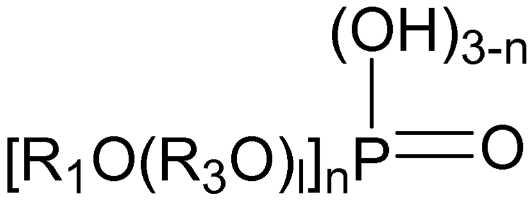 (2)

(In the formula (2),

$R_1$ represents a saturated or unsaturated hydrocarbyl group having a carbon number of 4 to 20;
$R_3$ is a saturated hydrocarbylene group having a carbon group of 2 or 3;
1 represents an integer of 0 to 20;
n represents an integer of 1 or 2, wherein
where a plurality of $R_1$ exist, the plurality of $R_1$ may be the same or different from each other; and
where a plurality of $R_3$ exist, the plurality of $R_3$ may be the same or different from each other.)

In the formula (2), $R_1$ is not particularly limited as long as $R_1$ is a saturated or unsaturated hydrocarbyl group having a carbon number of 4 to 20. As $R_1$, examples of the saturated hydrocarbyl group include alkyl group such as butyl group, pentyl group, hexyl group, heptyl group, octyl group, 2-ethylhexyl group, nonyl group, decyl group, undecyl group, dodecyl group, hexadecyl group, and octadecyl group. Examples of the unsaturated hydrocarbyl group include phenyl group, nonylphenyl group, and oleyl group. The carbon number of $R_1$ is preferably 6 to 18, and especially where 1=0, the carbon number of $R_1$ is preferably 10 to 18. Specifically preferable groups for $R_1$ include decyl group, undecyl group and dodecyl group.
In the formula (2), $R_3$ is a saturated hydrocarbylene group having a carbon number of 2 or 3. The carbon number of $R_3$ is preferably 2. As a preferable group as $R_3$. ethylene group can be given.
In the formula (2), 1 is not particularly limited as long as 1 is an integer of 0 to 20. Preferably 1 is an integer of 0 to 10. In the formula (2), n is 1 or 2.
The acidic phosphate ester represented by the general formula (2) may be a mixture of a compound wherein n=1 and a compound wherein n=2. Also, where n=2 in the acidic phosphate ester represented by the general formula (2), the acidic phosphate ester can be a compound having different side chains in one molecule. That is, where n=2, two $R_1O(R_3O)_1$ groups may be the same as or different from each other. Further, the acidic phosphate ester represented by the general formula (2) may be a mixture of compound having different structures from each other. The acidic phosphate ester represented by the general formula (2) generally can be obtained as a mixture of the compound wherein n=1 and the compound wherein n=2.
Specific examples of the acidic phosphate ester represented by the general formula (2) include:

(1) an acidic phosphate ester being a mixture of a compound wherein n=1 and a compound wherein n=2, wherein $R_1$ is octyl group and 1 is 0;
(2) an acidic phosphate ester being a mixture of a compound wherein n=1 and a compound wherein n=2, wherein $R_1$ is octyl group, 1 is 1, and $R_3$ is ethylene group;
(3) an acidic phosphate ester being a mixture of a compound wherein n=1 and a compound wherein n=2, wherein $R_1$ is octyl group, 1 is 2, and $R_3$ is ethylene group;
(4) an acidic phosphate ester being a mixture of a compound wherein n=1 and a compound wherein n=2, wherein $R_1$ is decyl group and 1 is 0;
(5) an acidic phosphate ester being a mixture of a compound wherein n=1 and a compound wherein n=2, wherein $R_1$ is decyl group, 1 is 1, and $R_3$ is ethylene group;
(6) an acidic phosphate ester being a mixture of a compound wherein n=1 and a compound wherein n=2, wherein $R_1$ is decyl group, 1 is 2, and $R_3$ is ethylene group;
(7) an acidic phosphate ester being a mixture of a compound wherein n=1 and a compound wherein n=2, wherein $R_1$ is decyl group, 1 is 3, and $R_3$ is ethylene group;
(8) an acidic phosphate ester being a mixture of a compound wherein n=1 and a compound wherein n=2, wherein $R_1$ is undecyl group and 1 is 0;
(9) an acidic phosphate ester being a mixture of a compound wherein n=1 and a compound wherein n=2, wherein $R_1$ is undecyl group, 1 is 1, and $R_3$ is ethylene group;

(10) an acidic phosphate ester being a mixture of a compound wherein n=1 and a compound wherein n=2, wherein $R_1$ is undecyl group, 1 is 2, and $R_3$ is ethylene group;
(11) an acidic phosphate ester being a mixture of a compound wherein n=1 and a compound wherein n=2, wherein $R_1$ is undecyl group, 1 is 3, and $R_3$ is ethylene group;
(12) an acidic phosphate ester being a mixture of a compound wherein n=1 and a compound wherein n=2, wherein $R_1$ is undecyl group, 1 is 4, and $R_3$ is ethylene group;
(13) an acidic phosphate ester being a mixture of a compound wherein n=1 and a compound wherein n=2, wherein $R_1$ is undecyl group, 1 is 5, and $R_3$ is ethylene group;
(14) an acidic phosphate ester being a mixture of a compound wherein n=1 and a compound wherein n=2, wherein $R_1$ is undecyl group, 1 is 6, and $R_3$ is ethylene group;
(15) an acidic phosphate ester being a mixture of a compound wherein n=1 and a compound n=2, wherein $R_1$ is undecyl group, 1 is 7, and $R_3$ is ethylene group;
(16) an acidic phosphate ester being a mixture of a compound wherein n=1 and a compound wherein n=2, wherein $R_1$ is undecyl group, 1 is 8, and $R_3$ is ethylene group;
(17) an acidic phosphate ester being a mixture of a compound wherein n=1 and a compound wherein n=2, wherein $R_1$ is undecyl group, 1 is 9, and $R_3$ is ethylene group;
(18) an acidic phosphate ester being a mixture of a compound wherein n=1 and a compound wherein n=2, wherein $R_1$ is undecyl group, 1 is 10, and $R_3$ is ethylene group;
(19) an acidic phosphate ester being a mixture of a compound wherein n=1 and a compound wherein n=2, wherein $R_1$ is dodecyl group and 1 is 0;
(20) an acidic phosphate ester being a mixture of a compound wherein n=1 and a compound wherein n=2, wherein $R_1$ is dodecyl group, 1 is 1, and $R_3$ is ethylene group;
(21) an acidic phosphate ester being a mixture of a compound wherein n=1 and a compound wherein n=2, wherein $R_1$ is dodecyl group, 1 is 2, and $R_3$ is ethylene group;
(22) an acidic phosphate ester being a mixture of a compound wherein n=1 and a compound wherein n=2, wherein $R_1$ is dodecyl group, 1 is 3, and $R_3$ is ethylene group;
(23) an acidic phosphate ester being a mixture of a compound wherein n=1 and a compound wherein n=2, wherein $R_1$ is dodecyl group, 1 is 4, and $R_3$ is ethylene group;
(24) an acidic phosphate ester being a mixture of a compound wherein n=1 and a compound wherein n=2, wherein $R_1$ is dodecyl group, 1 is 5, and $R_3$ is ethylene group;
(25) an acidic phosphate ester being a mixture of a compound wherein n=1 and a compound wherein n=2, wherein $R_1$ is dodecyl group, 1 is 6, and $R_3$ is ethylene group;
(26) an acidic phosphate ester being a mixture of a compound wherein n=1 and a compound wherein n=2, wherein $R_1$ is dodecyl group, 1 is 7, and $R_3$ is ethylene group;
(27) an acidic phosphate ester being a mixture of a compound wherein n=1 and a compound wherein n=2, wherein $R_1$ is dodecyl group, 1 is 8, and $R_3$ is ethylene group;
(28) an acidic phosphate ester being a mixture of a compound wherein n=1 and a compound wherein n=2, wherein $R_1$ is dodecyl group, 1 is 9, and $R_3$ is ethylene group;
(29) an acidic phosphate ester being a mixture of a compound wherein n=1 and a compound wherein n=2, wherein $R_1$ is dodecyl group, 1 is 10, and $R_3$ is ethylene group;
(30) an acidic phosphate ester being a mixture of a compound wherein n=1 and a compound wherein n=2, wherein $R_1$ is octadecyl group and 1 is 0;
(31) an acidic phosphate ester being a mixture of a compound wherein n=1 and a compound wherein n=2, wherein $R_1$ is octadecyl group, 1 is 1, and $R_3$ is ethylene group;
(32) an acidic phosphate ester being a mixture of a compound wherein n=1 and a compound wherein n=2, wherein $R_1$ is octadecyl group, 1 is 2, and $R_3$ is ethylene group;
(33) an acidic phosphate ester being a mixture of a compound wherein n=1 and a compound wherein n=2, wherein $R_1$ is octadecyl group, 1 is 3, and $R_3$ is ethylene group;
(34) an acidic phosphate ester being a mixture of a compound wherein n=1 and a compound wherein n=2, wherein $R_1$ is octadecyl group, 1 is 4, and $R_3$ is ethylene group;
(35) an acidic phosphate ester being a mixture of a compound wherein n=1 and a compound wherein n=2, wherein $R_1$ is octadecyl group, 1 is 5, and $R_3$ is ethylene group;
(36) an acidic phosphate ester being a mixture of a compound wherein n=1 and a compound wherein n=2, wherein $R_1$ is octadecyl group, 1 is 6, and $R_3$ is ethylene group;
(37) an acidic phosphate ester being a mixture of a compound wherein n=1 and a compound wherein n=2, wherein $R_1$ is octadecyl group, 1 is 7, and $R_3$ is ethylene group;
(38) an acidic phosphate ester being a mixture of a compound wherein n=1 and a compound wherein n=2, wherein $R_1$ is octadecyl group, 1 is 8, and $R_3$ is ethylene group;

(39) an acidic phosphate ester being a mixture of a compound wherein n=1 and a compound wherein n=2, wherein $R_1$ is octadecyl group, 1 is 9, and $R_3$ is ethylene group;
(40) an acidic phosphate ester being a mixture of a compound wherein n=1 and a compound wherein n=2, wherein $R_1$ is octadecyl group, 1 is 10, and $R_3$ is ethylene group;
(41) An acidic phosphate ester being a mixture of:

a compound wherein $R_1$ is hexyl group, 1 is 0, and n is 1;
a compound wherein $R_1$ is hexyl group, 1 is 0, and n is 2;
a compound wherein $R_1$ is heptyl group, 1 is 0, and n is 1;
a compound wherein $R_1$ is heptyl group, 1 is 0, and n is 2;
a compound wherein $R_1$ is octyl group, 1 is 0, and n is 1;
a compound wherein $R_1$ is octyl group, 1 is 0, and n is 2;
a compound wherein $R_1$ is nonyl group, 1 is 0, and n is 1;
a compound wherein $R_1$ is nonyl group, 1 is 0, and n is 2;
a compound wherein $R_1$ is decyl group, 1 is 0, and n is 1; and
a compound wherein $R_1$ is decyl group, 1 is 0, and n is 2;

(42) the acidic phosphate ester of the above (41) wherein in the compounds wherein n=2, one of two $R_1$ is the group specified for each of the compounds (for example, in the "compound wherein $R_1$ is decyl group, 1 is 0, and n is 2", the decyl group is specified) and the other $R_1$ is hexyl group, hepthyl group, octyl group, nonyl group or decyl group;
(43) an acidic phosphate ester being a mixture of:

a compound wherein $R_1$ is hexyl group, 1 is 1, $R_3$ is ethylene group, and n is 1;
a compound wherein $R_1$ is hexyl group, 1 is 1, $R_3$ is ethylene group, and n is 2;
a compound wherein $R_1$ is hepthyl group, 1 is 1, $R_3$ is ethylene group, and n is 1;
a compound wherein $R_1$ is hepthyl group, 1 is 1, $R_3$ is ethylene group, and n is 2;
a compound wherein $R_1$ is octyl group, 1 is 1, $R_3$ is ethylene group, and n is 1;
a compound wherein $R_1$ is an octyl group, 1 is 1, $R_3$ is ethylene group, and n is 2;
a compound wherein $R_1$ is nonyl group, 1 is 1, $R_3$ is ethylene group, and n is 1;
a compound wherein $R_1$ is nonyl group, 1 is 1, $R_3$ is ethylene group, and n is 2;
a compound wherein $R_1$ is decyl group, 1 is 1, $R_3$ is ethylene group, and n is 1; and
a compound wherein $R_1$ is decyl group, 1 is 1, $R_3$ is ethylene group, and n is 2;

(44) the acidic phosphate ester of the above (43) wherein in the compounds wherein n=2, one of two $R_1$ is the group specified for each of the compounds (for example, in the "compound wherein $R_1$ is decyl group, 1 is 1, $R_3$ is ethylene group, and n is 2", the decyl group is specified) and the other $R_1$ is hexyl group, heptyl group, octyl group, nonyl group or decyl group;
(45) an acidic phosphate ester being a mixture of:

a compound wherein $R_1$ is hexyl group, 1 is 2, $R_3$ is ethylene group, and n is 1;
a compound wherein $R_1$ is hexyl group, 1 is 2, $R_3$ is ethylene group, and n is 2;
a compound wherein $R_1$ is heptyl group, 1 is 2, $R_3$ is ethylene group, and n is 1;
a compound wherein $R_1$ is heptyl group, 1 is 2, $R_3$ is ethylene group, and n is 2;
a compound wherein $R_1$ is octyl group, 1 is 2, $R_3$ is ethylene group, and n is 1;
a compound wherein $R_1$ is octyl group, 1 is 2, $R_3$ is ethylene group, and n is 2;
a compound wherein $R_1$ is nonyl group, 1 is 2, $R_3$ is ethylene group, and n is 1;
a compound wherein $R_1$ is nonyl group, 1 is 2, $R_3$ is ethylene group, and n is 2;
a compound wherein $R_1$ is decyl group, 1 is 2, $R_3$ is ethylene group, and n is 1; and
a compound wherein $R_1$ is decyl group, 1 is 2, $R_3$ is ethylene group, and n is 2;

(46) the acidic phosphate ester of the above (45) wherein in the compounds wherein n=2, one of two $R_1$ is the group specified for each of the compounds (for example, in the "compound wherein $R_1$ is decyl group, 1 is 2, $R_3$ is ethylene group, and n is 2", the decyl group is specified) and the other $R_1$ is hexyl group, heptyl group, octyl group, nonyl group or decyl group;
(47) an acidic phosphate ester being a mixture of:

a compound wherein $R_1$ is hexyl group, 1 is 3, $R_3$ is ethylene group, and n is 1;
a compound wherein $R_1$ is hexyl group, 1 is 3, $R_3$ is ethylene group, and n is 2;

a compound wherein $R_1$ is heptyl group, 1 is 3, $R_3$ is ethylene group, and n is 1;
a compound wherein $R_1$ is heptyl group, 1 is 3, $R_3$ is ethylene group, and n is 2;
a compound wherein $R_1$ is octyl group, 1 is 3, $R_3$ is ethylene group, and n is 1;
a compound wherein $R_1$ is octyl group, 1 is 3, $R_3$ is ethylene group, and n is 2;
a compound wherein $R_1$ is nonyl group, 1 is 3, $R_3$ is ethylene group, and n is 1;
a compound wherein $R_1$ is nonyl group, 1 is 3, $R_3$ is ethylene group, and n is 2;
a compound wherein $R_1$ is decyl group, 1 is 3, $R_3$ is ethylene group, and n is 1;
a compound wherein $R_1$ is decyl group, 1 is 3, $R_3$ is ethylene group, and n is 2;

(48) the acidic phosphate ester of the above (47) wherein in the compounds wherein n=2, one of two $R_1$ is the group specified for each of the compounds (for example, in the "compound wherein $R_1$ is decyl group, 1 is 3, $R_3$ is ethylene group, and n is 2", the decyl group is specified) and the other $R_1$ is hexyl group, heptyl group, octyl group, nonyl group or decyl group;
(49) an acidic phosphate ester being a mixture of:

a compound wherein $R_1$ is hexyl group, 1 is 4, $R_3$ is ethylene group, and n is 1;
a compound wherein $R_1$ is hexyl group, 1 is 4, $R_3$ is ethylene group, and n is 2;
a compound wherein $R_1$ is heptyl group, 1 is 4, $R_3$ is ethylene group, and n is 1;
a compound wherein $R_1$ is heptyl group, 1 is 4, $R_3$ is ethylene group, and n is 2;
a compound wherein $R_1$ is octyl group, 1 is 4, $R_3$ is ethylene group, and n is 1;
a compound wherein $R_1$ is octyl group, 1 is 4, $R_3$ is ethylene group, and n is 2;
a compound wherein $R_1$ is nonyl group, 1 is 4, $R_3$ is ethylene group, and n is 1;
a compound wherein $R_1$ is nonyl group, 1 is 4, $R_3$ is ethylene group, and n is 2;
a compound wherein $R_1$ is decyl group, 1 is 4, $R_3$ is ethylene group, and n is 1; and
a compound wherein $R_1$ is decyl group, 1 is 4, $R_3$ is ethylene group, and n is 2; and

(50) the acidic phosphate ester of the above (49) wherein in the compounds wherein n=2, one of two $R_1$ is the group specified for each of the compounds (for example, in the "compound wherein $R_1$ is decyl group, 1 is 3, $R_3$ is ethylene group, and n is 2", the decyl group is specified) and the other $R_1$ is hexyl group, heptyl group, octyl group, nonyl group or decyl group.

Among these compounds described above, preferable acidic phosphate esters include:

(5) an acidic phosphate ester being a mixture of a compound wherein n=1 and a compound wherein n=2, wherein $R_1$ is decyl group, 1 is 1, and $R_3$ is ethylene group;
(6) an acidic phosphate ester being a mixture of a compound wherein n=1 and a compound wherein n=2, wherein $R_1$ is decyl group, 1 is 2, and $R_3$ is ethylene group;
(7) an acidic phosphate ester being a mixture of a compound wherein n=1 and a compound wherein n=2, wherein $R_1$ is decyl group, 1 is 3, and $R_3$ is ethylene group;
(8) an acidic phosphate ester being a mixture of a compound wherein n=1 and a compound wherein n=2, wherein $R_1$ is undecyl group and 1 is 0;
(9) an acidic phosphate ester being a mixture of a compound wherein n=1 and a compound wherein n=2, wherein $R_1$ is undecyl group, 1 is 1, and $R_3$ is ethylene group;
(10) an acidic phosphate ester being a mixture of a compound wherein n=1 and a compound wherein n=2, wherein $R_1$ is undecyl group, 1 is 2, and $R_3$ is ethylene group;
(11) an acidic phosphate ester being a mixture of a compound wherein n=1 and a compound wherein n=2, wherein $R_1$ is undecyl group, 1 is 3, and $R_3$ is ethylene group;
(12) an acidic phosphate ester being a mixture of a compound wherein n=1 and a compound wherein n=2, wherein $R_1$ is undecyl group, 1 is 4, and $R_3$ is ethylene group;
(13) an acidic phosphate ester being a mixture of a compound wherein n=1 and a compound wherein n=2, wherein $R_1$ is undecyl group, 1 is 5, and $R_3$ is ethylene group;
(14) an acidic phosphate ester being a mixture of a compound wherein n=1 and a compound wherein n=2, wherein $R_1$ is undecyl group, 1 is 6, and $R_3$ is ethylene group;
(15) an acidic phosphate ester being a mixture of a compound wherein n=1 and a compound n=2, wherein $R_1$ is undecyl group, 1 is 7, and $R_3$ is ethylene group;
(16) an acidic phosphate ester being a mixture of a compound wherein n=1 and a compound wherein n=2, wherein $R_1$ is undecyl group, 1 is 8, and $R_3$ is ethylene group;
(17) an acidic phosphate ester being a mixture of a compound wherein n=1 and a compound wherein n=2, wherein

$R_1$ is undecyl group, 1 is 9, and $R_3$ is ethylene group;

(18) an acidic phosphate ester being a mixture of a compound wherein n=1 and a compound wherein n=2, wherein $R_1$ is undecyl group, 1 is 10, and $R_3$ is ethylene group;

(19) an acidic phosphate ester being a mixture of a compound wherein n=1 and a compound wherein n=2, wherein $R_1$ is dodecyl group and 1 is 0;

(20) an acidic phosphate ester being a mixture of a compound wherein n=1 and a compound wherein n=2, wherein $R_1$ is dodecyl group, 1 is 1, and $R_3$ is ethylene group;

(21) an acidic phosphate ester being a mixture of a compound wherein n=1 and a compound wherein n=2, wherein $R_1$ is dodecyl group, 1 is 2, and $R_3$ is ethylene group;

(22) an acidic phosphate ester being a mixture of a compound wherein n=1 and a compound wherein n=2, wherein $R_1$ is dodecyl group, 1 is 3, and $R_3$ is ethylene group;

(23) an acidic phosphate ester being a mixture of a compound wherein n=1 and a compound wherein n=2, wherein $R_1$ is dodecyl group, 1 is 4, and $R_3$ is ethylene group;

(24) an acidic phosphate ester being a mixture of a compound wherein n=1 and a compound wherein n=2, wherein $R_1$ is dodecyl group, 1 is 5, and $R_3$ is ethylene group;

(25) an acidic phosphate ester being a mixture of a compound wherein n=1 and a compound wherein n=2, wherein $R_1$ is dodecyl group, 1 is 6, and $R_3$ is ethylene group;

(26) an acidic phosphate ester being a mixture of a compound wherein n=1 and a compound wherein n=2, wherein $R_1$ is dodecyl group, 1 is 7, and $R_3$ is ethylene group;

(27) an acidic phosphate ester being a mixture of a compound wherein n=1 and a compound wherein n=2, wherein $R_1$ is dodecyl group, 1 is 8, and $R_3$ is ethylene group;

(28) an acidic phosphate ester being a mixture of a compound wherein n=1 and a compound wherein n=2, wherein $R_1$ is dodecyl group, 1 is 9, and $R_3$ is ethylene group; and

(29) an acidic phosphate ester being a mixture of a compound wherein n=1 and a compound wherein n=2, wherein $R_1$ is dodecyl group, 1 is 10, and $R_3$ is ethylene group.

Among the above acidic phosphate esters, commercially available acidic phosphate esters include:

(7) the acidic phosphate ester being a mixture of a compound wherein n=1 and a compound wherein n=2, wherein $R_1$ is decyl group, 1 is 3, and $R_3$ is ethylene group (PHOSPHANOL RS-410, manufactured by Toho Chemical Industry Co., Ltd.);

(14) the acidic phosphate ester being a mixture of a compound wherein n=1 and a compound wherein n=2, wherein $R_1$ is undecyl group, 1 is 6, and $R_3$ is ethylene group (PHOSPHANOL RS-610, manufactured by Toho Chemical Industry Co., Ltd.);

(18) the acidic phosphate ester being a mixture of a compound wherein n=1 and a compound wherein n=2, wherein $R_1$ is undecyl group, 1 is 10, and $R_3$ is ethylene group (PHOSPHANOL RS-710, manufactured by Toho Chemical Industry Co., Ltd.);

(32) the acidic phosphate ester being a mixture of a compound wherein n=1 and a compound wherein n=2, wherein $R_1$ is octadecyl group, 1 is 2, and $R_3$ is ethylene group (PHOSPHANOL RL-310, manufactured by Toho Chemical Industry Co., Ltd.);

(50) an acidic phosphate ester being a mixture of a compound wherein n=1 and a compound wherein n=2, wherein $R_1$ is a mixture of hexyl group, heptyl group, octyl group, nonyl group, and decyl group, 1 is 4, and $R_3$ is ethylene group (PHOSPHANOL RA-600, manufactured by Toho Chemical Industry Co., Ltd.);

(19a) an acidic phosphate ester being a mixture of a compound wherein n=1 and a compound wherein n=2, wherein $R_1$ is dodecyl group, 1 is 0, and the content (mol) of the compound wherein n=1 is larger than the content (mol) of the compound wherein n=2 (PHOSPHANOL ML-200, manufactured by Toho Chemical Industry Co., Ltd.);

(21) the acidic phosphate ester being a mixture of a compound wherein n=1 and a compound wherein n=2, wherein $R_1$ is dodecyl group, 1 is 2, and $R_3$ is ethylene group (PHOSPHANOL ML-220, manufactured by Toho Chemical Industry Co., Ltd.);

(23) the acidic phosphate ester being a mixture of a compound wherein n=1 and a compound wherein n=2, wherein $R_1$ is dodecyl group, 1 is 4, and $R_3$ is ethylene group (PHOSPHANOL ML-240, manufactured by Toho Chemical Industry Co., Ltd.); and

(19b) an acidic phosphate ester being a mixture of a compound wherein n=1 and a compound wherein n=2, wherein $R_1$ is dodecyl group, 1 is 0, and the content (mol) of the compound wherein n=1 and the content (mol) of the compound wherein n=2 are almost the same (PHOSPHANOL GF-199, manufactured by Toho Chemical Industry Co., Ltd.).

(Content)

Content of the aluminum nitride particles in the curable resin composition of the present invention is not particularly limited. In view of further increasing the thermal conductivity of the high thermal conductive resin composition obtained by curing the curable resin composition, the content of the aluminum nitride particles is preferably no less than 50 parts by mass, more preferably no less than 100 parts by mass, and most preferably no less than 200 parts by mass, to 100 parts by mass of the total amount of the epoxy resin, the curing agent, and the acidic phosphate ester. Also, in view of viscosity, fluidity and workability of the curable resin composition, the content of the aluminum nitride particles is preferably no more than 900 parts by, and more preferably no more than 600 parts by mass.

Content of the curing agent in the curable resin composition of the present invention can be adequately determined by the skilled person in the art, with consideration of characteristics of the curing agent, an epoxy equivalent of the epoxy resin, content of the acidic phosphate ester and the aluminum nitride particles and the like. Generally, the content of the curing agent is 0.1 to 200 parts by mass, and more preferably 0.4 to 150 parts by mass, to 100 parts by mass of the epoxy resin.

Content of the acidic phosphate ester represented by the general formula (1) in the curable resin composition of the present invention can be adequately determined by the skilled person in the art, with consideration of characteristics of the epoxy resin, characteristics of the curing agent, the specific surface area of the aluminum nitride particles and the like. In view of bringing out the physical properties inherent in the epoxy resin while keeping sufficient affinity between the aluminum nitride particles and the epoxy resin, the content of the acidic phosphate ester represented by the general formula (1) is preferably 0.4 to 5 parts by mass, and more preferably 0.6 to 4 parts by mass, to 100 parts by mass of the epoxy resin.

(Other components)

The curable resin composition of the present invention may contain components other than the components described above if needed. Examples of such components include: monofunctional or multifunctional isocyanate compounds such as hexyl isocyanate, octyl isocyanate, decyl isocyanate, dodecyl isocyanate, and hexamethylene diisocyanate; blocked isocyanate compounds in which terminal(s) of the monofunctional or multifunctional isocyanate compounds is protected by a blocking agent such as phenols, alcohols, and oximes; carbodiimide compounds; urethane compounds; and Lewis acid compounds such as acetylacetone aluminium. Among them, Lewis acid compounds are effective for pot-life extension of the curable resin composition of the present invention. The content of these components is normally no more than 50 parts by mass and preferably no more than 40 parts by mass, to 100 parts by mass of the epoxy resin. The content beyond the upper limit described above may lead to worse physical properties of the epoxy resin, which for example decreases the adhesive strength of the laminated substrate.

<2. Manufacturing method of curable resin composition>

A manufacturing method of the curable resin composition according to the second aspect of the present invention will be described.

The curable resin composition of the present invention may be manufactured by mixing aluminum nitride particles, an epoxy resin, a curing agent, and the acidic phosphate ester represented by the above formula (1). The order of mixing each component of the curable resin composition is not particularly limited. However, in a case (a) or (b):

(a) where only the aluminum nitride particles and the acidic phosphate ester represented by the above general formula (1) are mixed in advance, and thereafter the resultant mixture is mixed with other components (such as the epoxy resin and the curing agent) not including the acidic phosphate ester represented by the above general formula (1); or

(b) where the aluminum nitride particles are subjected to surface treatment with the acidic phosphate ester represented by the above general formula (1), thereafter the particles are mixed with other components (such as the epoxy resin and the curing agent) not including the acidic phosphate ester represented by the above general formula (1),

the effect of give a high thermal conductivity to the resin composition after curing becomes inferior. Therefore, it is preferred to carry out the mixing step in a order other than the above (a) or (b). Although the reason for this has not been clearly figured out, it is considered to be because where the aluminum nitride particles and the acidic phosphate ester have contact with each other in advance, side chains of the acidic phosphate ester on the surface of the aluminum nitride particles contract, whereby the affinity between the aluminum nitride particles and the epoxy resin becomes inferior. In other words, in the curable resin composition manufactured by the mixing order of the above (a) and (b), it is

not the case that "the aluminum nitride particles, the epoxy resin, the curing agent and the acidic phosphate ester represented by the above general formula (1) are mixed with each other".

As the mixing order of each component of the curable resin composition, it is preferred, as shown in the flowchart S1 of Fig. 1, to go through a step (S11) of mixing the aluminum nitride particles are with a mixture containing the acidic phosphate ester represented by the above general formula (1) and all or a portion of the epoxy resin, in view of giving a high thermal conductivity to the resin composition after curing. The reason for this is presumed that, by mixing the acidic phosphate ester represented by the above general formula (1) and the epoxy resin in advance, the side chains of the acidic phosphate ester are sufficiently extended, whereby a good affinity with the epoxy resin is obtained. In the step S11, although the content of the epoxy resin in "the mixture containing the acidic phosphate ester represented by the above general formula (1) and all or a portion of the epoxy resin" is not particularly limited, normally no less than 70 parts by mass, preferably no less than 100 parts by mass, more preferably no less than 150 parts by mass, and especially preferably no less than 200 parts by mass, to 100 parts by mass of the acidic phosphate ester represented by the above general formula (1) in the mixture. In the step S11, "the mixture containing the acidic phosphate ester represented by the above formula (1) and all or a portion of the epoxy resin" may include a curing agent, and does not have to include the curing agent. However, preferably it does not include the aluminum nitride particles.

After the step S11, where the mixing of all materials to be mixed is completed (i.e. where an affirmative judgment is done in a judgment step S12), the manufacturing method S1 ends. After the step S11, where unmixed materials to be mixed (such as the remaining portion of the epoxy resin, the curing agent and so on) exist (i.e. where a negative judgment is done in the judgment step S12), the mixture obtained in the step S11 and the unmixed materials to be mixed are mixed (step S13).

Typically, for example, as shown by a flowchart S2 of Fig. 2, the curable resin composition of the present invention may be preferably manufactured by mixing the acidic phosphate ester represented by the above general formula (1) and the epoxy resin (step S21), and thereafter mixing (S22) the mixture obtained in the S21 and the other components (such as the aluminum nitride particles and the curing agent).

In the manufacturing method of the curable resin composition of the present invention, it is preferable to make the aluminum nitride particles and the acidic phosphate ester represented by the above general formula (1) have contact with each other before making the curing agent and the acidic phosphate ester represented by the above general formula (1) have contact with each other, which is particularly pronounced where a basic curing agent such as amines or imidazoles is used. Specifically, as shown by a flowchart S3 of Fig. 3 for example, it is preferable to: mix the acidic phosphate ester and all or a portion of the epoxy resin (step S31); thereafter mix the mixture obtained in the step S31 and the aluminum nitride particles (step S32); and thereafter mix the mixture obtained in the step S32, the remaining portion of the epoxy resin, and the curing agent (step S33). In the step S33, the remaining portion of the epoxy resin and the curing agent may be mixed at the same time, or may be successively mixed.

Where the step S33 is successively carried out, as shown in a flowchart S4 of Fig. 4, it is preferable to employ the order of: mixing the acidic phosphate ester and all or a portion of the epoxy resin (step S41); thereafter mixing the mixture obtained in the step S41 and the aluminum nitride particles (step S42); thereafter mixing the mixture obtained in S42 and the remaining portion of the epoxy resin (step S43); and finally mixing the mixture obtained in the step 43 and the curing agent (basic curing agent) (step S44).

It is also preferable to carry out an aging step (i.e. keeping the mixture while heating) after the step of mixing the aluminum nitride particles, that is, between S32 and S33 in the flowchart S3 of Fig. 3, or between S42 and S43 in the flowchart S4 of Fig. 4. A general heating temperature in the aging step is 40 to 100°C, and a general heating time is 1 to 72 hours.

Although the reason why the mixing order in which the aluminum nitride particles and the acidic phosphate ester represented by the above general formula (1) are brought into contact before the curing agent and the acidic phosphate ester represented by the above general formula (1) are brought into contact is preferred has not been clearly figured out, it is considered to be because in a case where the curing agent is a basic curing agent, if the basic curing agent and the acidic phosphate ester represented by the above general formula (1) have contact with each other before the aluminum nitride particles and the acidic phosphate ester have contact with each other, the function of the curing agent can be degraded due to salt formation of the basic curing agent and the acidic phosphate ester. Since the aluminum nitride itself is basic, it is considered that promoting absorption of acidic phosphate ester molecules to a surface of the aluminum nitride particles makes it possible to sufficiently exert the effect of the acidic phosphate ester represented by the above general formula (1), and also makes it possible to inhibit adverse effects to other basic components or components not being basic as a whole but having a basic reactive site. And it is considered that, according to the embodiment in which the aging is carried out after mixing the aluminum nitride particles, it is possible to further promote the absorption of the acidic phosphate ester molecules to the surface of the aluminum nitride particles.

In the manufacturing method of the curable resin composition of the present invention, mixing method is not particularly limited. In mixing, a known mixing apparatus can be used without particular limitations. Specific examples of the mixing apparatus include: kneaders such as planetary mixers, and a tri-mix, roll kneaders such as a three roll,

and grinders.

In a case where all the components to be mixed are solid at normal temperature, they may be mixed in a melted state. The solid components may be dissolved in a solvent and then subjected to mixing as a solution, and thereafter the solvent may be dried and removed, if needed.

<3. High thermal conductive resin composition>

The high thermal conductive resin composition according to the third aspect of the present invention will be described.

The high thermal conductive resin composition according to the third aspect of the present invention can be obtained by curing the curable resin composition according to the first aspect of the present invention. The curing of the epoxy resin can be divided into two main classes: one is heat curing, and the other is photo curing by means of energy irradiation such as light. They may be adequately selected according to its purpose of use. The heat curing is generally selected in manufacturing a laminated substrate. A heating temperature in heat curing is normally 120°C to 220°C and preferably 140°C to 200°C.

Although the thermal conductivity of the high thermal conductive resin composition of the present invention is not particularly limited, it is preferably no less than 4 W/m•K, and more preferably no less than 5 W/m•K, in view of reducing the heat resistance of the high thermal conductive laminated substrate according to the fourth aspect of the present invention which is described later.

<4. High thermal conductive laminated substrate>

The high thermal conductive laminated substrate according to the fourth aspect of the present invention will be described.

The curable resin composition according to the first aspect of the present invention may be used as a resin adhesive agent. For example, as shown in Fig. 5, a metal substrate or a high thermal conductive ceramics substrate 1 (hereinafter may be referred to as "substrate 1" for short) and a metallic foil 2 for forming a circuit are layered via a curable resin composition 3 of the present invention. Thereafter, by curing the curable resin composition 3, as shown in Fig. 6, a high thermal conductive laminated substrate 10 (hereinafter may be referred to as "laminated substrate 10" for short) in which the metallic foil 2, a high thermal conductive resin composition layer 4 being a cured body of the curable resin composition 3, and the metal or high thermal conductive ceramics substrate 1 are layered in the order mentioned can be manufactured.

(Substrate: metal substrate)

Where the substrate 1 in the laminated substrate 10 of the present invention is a metal substrate, any metal substrate generally used for a dissipation substrate may be used as the metal substrate without particular limitations. Examples of preferable materials for the metal substrate include: copper, aluminum, copper-tungsten alloy, copper-molybdenum alloy, and Al-SiC in which aluminum is impregnated with SiC.

(Substrate: high thermal conductive ceramics substrate)

Where the substrate 1 in the laminated substrate 10 of the present invention is a high thermal conductive ceramics substrate, the high thermal conductive ceramics substrate is a ceramics substrate having a sufficient thermal conductivity to dissipate the heat generated from a semiconductor device, and the thermal conductivity of the ceramics substrate is preferably no less than 30 W/m•K, and more preferably no less than 70 W/m•K. Specific examples of the high thermal conductive ceramics substrate which can be used for the present invention include: an aluminum nitride substrate, a silicon nitride substrate, and an alumina substrate. Among them, especially where a high heat dissipation is required, it is especially preferable to employ the aluminum nitride substrate or the silicon nitride substrate.

Thickness of the substrate 1 of the laminated substrate 10 of the present invention is not particularly limited. In view of reducing the heat resistance of the substrate, though, it is not preferable to make the substrate 1 unnecessarily thick. Therefore, the thickness of the metal or high thermal conductive ceramics substrate 1 is preferably 0.3 mm to 10 mm.

(Metallic foil)

As the metallic foil 2 in the laminated substrate 10 of the present invention, a known metallic foil such as a gold foil, silver foil, copper foil and aluminum foil may be employed. In view of electronic conductivity and cost, the copper foil is preferably used. Although the thickness of the copper foil is not particularly limited, it is generally 5 to 105 μm, and

preferably 8 to 35 μm. Producing method of the copper foil is not particularly limited, and a rolled copper foil or an electrolytic copper foil is generally used.

(High thermal conductive resin composition layer)

The thickness of the high thermal conductive resin composition layer 4 in the laminated substrate 10 of the present invention is not particularly limited, and may be adequately determined by the skilled person in the art with consideration of insulation performance, adhesive strength, durability and the like. In a case where the substrate 1 is a metal substrate, since the high thermal conductive resin composition layer 4 is required to have properties as an insulating layer, the thickness of the high thermal conductive resin composition layer 4 is normally 20 to 300 μm, preferably 40 to 250 μm, and more preferably 50 to 200 μm. If the thickness of the high thermal conductive resin composition layer 4 is below the lower limit as described above, the insulation performance may be inferior. If the thickness of the high thermal conductive resin composition layer 4 is beyond the upper limit as described above, the heat conductivity of the laminated substrate 10 may be inferior. On the other hand, where the substrate 1 is a high conductive ceramics substrate, in view of reducing the heat resistance at interfaces, the thickness of the high thermal conductive resin composition layer 4 is preferably 1 to 20 μm, and more preferably 2 to 10 μm.

(Thermal conductivity)

The thermal conductivity of the high thermal conductive laminated substrate 10 of the present invention is desirable to be evaluated without the metallic foil 2, since the thermal conductivity of the whole substrate largely differs depending on the thickness of the metallic foil 2. The thermal conductivity $\lambda_1$ of a composite layer 5 (see Fig. 6; hereinafter may be referred to as "composite layer 5" for short) consisting of the substrate 1 and the high thermal conductive resin composition layer 4 can be theoretically calculated from the following formula (3) representing the relationship between the thermal conductivity of each layer and the thickness of each layer and the following formula (4).
[Formula 1]

$$\frac{d_1}{\lambda_1} = \frac{d_2}{\lambda_2} + \frac{d_3}{\lambda_3} \qquad \cdots(3)$$

(in the formula (3),

- $d_1$ represents the thickness of the complex layer 5;
- $d_2$ represents the thickness of the high thermal conductive resin composition layer 4;
- $d_3$ represents the thickness of the metal or high thermal conductive ceramics substrate 1;
- $\lambda_1$ represents the thermal conductivity of the complex layer 5;
- $\lambda_2$ represents the thermal conductivity of the high thermal conductive resin composition layer 4; and
- $\lambda_3$ represents the thermal conductivity of the metal or high thermal conductive ceramics substrate 1.)

From the above formula (3), the thermal conductivity $\lambda_1$ of the composite layer 5 may be theoretically obtained with the following formula (4).
[Formula 2]

$$\lambda_1 = d_1/(d_2/\lambda_2 + d_3/\lambda_3) \qquad \cdots(4)$$

Thermal conductivity of the composite layer 5 is preferably no less than 20 W/m•K, and more preferably no less than 30 W/m•K.

<5. Manufacturing method of high thermal conductive laminated substrate>

The high thermal conductive laminated substrate according to the fifth aspect of the present invention will be described.

As a process of manufacturing the high thermal conductive laminated substrate 10 of the present invention, for example, a known process as a manufacturing process of a laminated substrate such as a metallic base substrate can be employed without particular limitations. In specific, as shown by a flowchart S10 of Fig. 7 for example, a method of: applying the curable resin composition of the present invention on a surface of the substrate 1 (step S101); adhering the metallic foil 2 and the substrate 1 by pressing (step S102 and Fig. 5); thereafter curing the resin layer consisting of the curable resin composition 3 by heating (step S103 and Fig. 6) can be given.

In the step S101, in a case where the viscosity of the curable resin composition is high, as shown in a flowchart S11 of Fig. 8, it is possible to apply a solution in which the curable resin composition is dissolved in a solvent (step S111). In this case, after applying the solution of the curable resin composition, the solvent is dried and removed before adhering the metallic foil 2 by pressing (step S112). The heating temperature in the step S112 may be adequately determined depending on the composition of the curable resin composition, and it is generally 120°C to 220°C, and preferably 140°C to 200°C. After that, as in the manufacturing method S10 described above, the metallic foil 2 and the substrate 1 are adhered by pressing (the step S113 and Fig. 5), thereafter the resin layer consisting of the curable resin composition 3 is cured by heating (the step S114 and Fig. 6), whereby the high thermal conductive laminated substrate 10 can be manufactured.

In the above description regarding the manufacturing method of the high thermal conductive laminated substrate of the present invention, the manufacturing methods S10 and S11 have been explained, in which the curable resin composition 3 of the present invention is applied on the surface of the substrate 1 and thereafter the metallic foil 2 and the substrate 1 are adhered by pressing. It should be noted, however, that the manufacturing method of the high thermal conductive laminated substrate of the present invention is not limited to these embodiments, and can be a manufacturing method in which the curable resin composition is formed on the surface of the metallic foil in advance. As shown by the flowchart S12 of Fig. 9 for example, the high thermal conductive laminated substrate 10 may be manufactured by: applying the curable resin composition of the present invention to the metallic foil 2 to form a layer of the curable resin composition 3 on a surface of the metallic foil 2 (step S121); adhering the metallic foil 2 with the layer of the curable resin composition 3 formed on the surface of the metallic foil 2 to the substrate 1 by pressing (step S122 and Fig. 5); and curing the layer of the curable resin composition 3 by heating (step S123 and Fig. 6).

In the manufacturing method of the high thermal conductive laminated substrate of the present invention, in order to improve adhesion of the substrate 1 and the metallic foil 2, an adhesion promoter component such as a silane coupling agent, a titanate coupling agent, an anionic surfactant, a nonionic surfactant, an organic acidic phosphate ester compound and a phosphonic acid compound, may be contained in the curable resin composition of the present invention. Also, instead of incorporating those adhesion promoter components to the curable resin composition, the adhesion promoter component can be applied to the surface of the substrate 1 and/or the surface of the metallic foil 2, and thereafter the adhesion promoter component and the curable resin composition may be brought into contact. For example, as shown by the flowchart S13 of Fig. 10, the high thermal conductive laminated substrate 10 of the present invention may be manufactured by: preparing a primer solution by diluting the adhesion promoter component with a solvent (step S131); applying the primer solution on the surface of the substrate 1 and/or the surface of the metallic foil 2 by means of spraying, spin coating, dipping and the like (step S132); removing the solvent by drying the applied primer solution (step S133); and thereafter applying the curable resin composition of the present invention on the surface of the substrate 1 or on the surface of the metallic foil 2 to form the layer of the curable resin composition 3 (step S134); adhering the metallic foil 2 to the substrate 1 by pressing (step S135); and curing the layer of the curable resin composition 3 by heating (step 136). The primer solution may contain the epoxy resin or the curing agent in addition to the solvent and the adhesion promoter component.

Particularly, in a case where the substrate 1 is an aluminum substrate, an alumina substrate or an aluminum nitride substrate, it is preferable to employ an organic acidic phosphate ester compound or a phosphonic acid compound as the adhesion promoter component, and to apply the primer solution thereof on the surface of the substrate 1.

The purpose of use of the high thermal conductive laminated substrate of the present invention is not particularly limited. The high thermal conductive laminated substrate of the present invention can be used for known purposes of use as an electronic circuit substrate which is required heat dissipation and insulation quality, without particular limitations. Examples of the purpose of use of the high thermal conductive laminated substrate of the present invention include: application for power electronics such as convertors and inverters, application for LEDs such as illumination LEDs, industrial LEDs and LEDs for vehicles, and application for substrate for IC or LSI.

Examples

Hereinafter the present invention will be specifically described with reference to Examples and Application examples. However, the present invention is not limited to these examples.

<Testing method>

(1) Viscosity of curable resin composition

Using a dynamic viscoelasticity measuring device (STRESS TECH, manufactured by SEIKO Instruments Inc.), with parallel plates each having a diameter of 20 mm, under conditions of a gap width of 1.00 mm, a measuring temperature of 25°C, a frequency of 0.1 Hz and a steady stress of 1000 Pa, a viscosity of the obtained curable resin composition of 120 seconds after start of the measurement was obtained.

(2) Thermal conductivity of high thermal conductive resin composition

After diluting the obtained curable resin composition with toluene or 2-methoxyethanol to have a suitable viscosity, the resultant composition was formed into a film on a mold release PET film by means of a bar coater (PI-1210, manufactured by Tester Sangyo Co., Ltd). After curing under a temperature of 180°C, the PET film was removed. The thickness of the film after curing was about 200 to 300 μm. The heat conductivity of samples was measured by means of a quick thermal conductivity meter (QTM-500, manufactured by Kyoto Electronics Manufacturing Co., Ltd.). As references, a quartz glass, a silicone rubber and a zirconia each having a thickness of 2 cm, a length of 15 cm and a width of 6 cm were used.

(3) Thickness of high thermal conductive resin composition

The obtained high thermal conductive laminated substrate was cut and a cross section was observed by means of a scanning electron microscope (JSM-5300, manufactured by JEOL Ltd.) at 100-fold, 500-fold or 2000-fold magnification, and thicknesses at ten points taken at the same intervals in one visual field of the high thermal conductive resin composition layer were measured, and arithmetic mean of the measured values was determined as the thickness of the high thermal conductive resin composition. The sample of the high thermal conductive resin composition layer having a thickness of 100 μm or more was measured at 100-fold magnification, the sample of the high thermal conductive resin composition layer having a thickness of 10 μm or more and less than 100 μm was measured at 500-fold magnification, and the sample of the high thermal conductive resin composition layer having a thickness of less than 10 μm was measured at 2000-fold magnification.

(4) Adhesive strength of high thermal conductive laminated substrate

After Ni plating followed by Au plating were performed on a surface of the copper foil of the obtained high thermal conductive laminated substrate, a nail head pin made of 42 alloy having a tip diameter of 1.1 mm and having Ni plating on the surface was soldered by means of a Pb-Sn solder to the surface of the Au plating, then the nail head pin was pulled in a vertical direction at a speed of 10 mm/min. The maximum tensile strength when the nail head pin was removed was determined as an adhesive strength (MPa).

(5) Insulation quality test

The obtained high thermal conductive laminated substrate went through a conditioning for 24 hours under a temperature of 20°C and a humidity of 85%, thereafter an alternative current of 1 kV was applied to the substrate in a thickness direction of the substrate for 1 minute. The substrate whose insulating layer was destroyed was evaluated to have "failed" the test and the substrate whose insulating layer was not destroyed was evaluated to have "passed" the test.

<Examples 1 to 20 and Comparative Examples 1 to 8>

The followings are Examples in which the curable resin compositions according to the first aspect of the present invention were manufactured, and Comparative Examples in which the curable resin compositions were tried to be manufactured.

(Example 1)

A uniform solution was obtained by mixing 5 g of a bisphenol A type epoxy resin (JER1004, manufactured by Mitsubishi Chemical Corporation), 5 g of o-cresol novolac type epoxy resin (YDCN703, manufactured by Tohto Chemical Industry Co., Ltd), 0.2 g of 1-cyanoethyl-2-phenylimidazolium trimellitate (2PZCN-PW, manufactured by Shikoku Chemicals Corporation) and 0.1 g of acidic phosphate ester (phosphanol RS-410, manufactured by TOHO Chemical Industry Co., Ltd.). To the resultant solution, 35 g of aluminum nitride particles (Grade H, having a BET specific surface area of 2.6 $m^2/g$, manufactured by Tokuyama Corporation) was added and kneaded.

Measurement results of the viscosity and the thermal conductivity after curing of the obtained curable resin composition are shown in Table 1.

(Example 2)

Acidic phosphate ester (Phosphanol RS-610, manufactured by TOHO Chemical Industry Co., Ltd.) in an amount of 0.3 g was dissolved to 2 g of bisphenol F type epoxy resin (EXA-830CRP, manufactured by DIC Corporation) and the resultant solution was kneaded with 45 g of aluminum nitride particles (Grade H, manufactured by Tokuyama Corporation). To the resultant mixture, a uniform mixture of 8 g of bisphenol F type epoxy resin (EXA-830CRP, manufactured by DIC Corporation) and 0.2 g of 2-ethyl-4-methylimidazole (2E4MZ, manufactured by Shikoku Chemicals Corporation) was added and further kneaded.

Measurement results of the viscosity and the thermal conductivity after curing of the obtained curable resin composition are shown in Table 1.

(Example 3)

A uniform solution was obtained by mixing 10 g of bisphenol F type epoxy resin (EXA-830CRP, manufactured by DIC Corporation), 0.2 g of 2-ethyl-4-methylimidazole (2E4MZ, manufactured by Shikoku Chemicals Corporation) and 0.2 g of acidic phosphate ester (phosphanol RA-600, manufactured by TOHO Chemical Industry Co., Ltd.). To the resultant solution, 40 g of aluminum nitride particles (Grade H, manufactured by Tokuyama Corporation) was added and kneaded.

Measurement results of the viscosity and the thermal conductivity after curing of the obtained curable resin composition are shown in Table 1.

(Comparative Example 1)

A uniform mixture was obtained by heating 1 kg of aluminum nitride particles (Grade H, manufactured by Tokuyama Corporation), 5 g of acidic phosphate ester (phosphanol RA-600, manufactured by TOHO Chemical Industry Co., Ltd.) and 1 kg of water. The resultant mixture was subjected to three times of treatment with an ultrasonic disperser (GSD600HAT, manufactured by Ginsen Co., Ltd.) three times at a flowing amount of 0.5 L/min, dried by means of a spray drier (R-100, manufactured by PRECI CO., LTD.) with an entrance temperature of 200°C, and then dried in vacuo at 80°C for 15 hours. The obtained particles were named as water-resistant aluminum nitride particles C.

A curable resin composition was obtained in the same manner as in Example 3 except that the water-resistant aluminum nitride particles C was used and the acidic phosphate ester was not added.

Measurement results of the viscosity and the thermal conductivity after curing of the obtained curable resin composition are shown in Table 1.

(Example 4)

Acidic phosphate ester (Phosphanol RS-710, manufactured by TOHO Chemical Industry Co., Ltd.) in an amount of 0.35 g was dissolved in 1 g of bisphenol A type epoxy resin (EXA-4850-150, manufactured by DIC Corporation), and the resultant solution was kneaded with 20 g of aluminum nitride particles (Grade H, manufactured by Tokuyama Corporation) and 30 g of spherical alumina particles (DAW-45, BET specific surface area: 0.2 $m^2/g$, manufactured by DENKI KAGAKU KOGYO KABUSHIKI KAISHA). To the resultant mixture, a uniform mixture of 9 g of bisphenol A type epoxy resin (EXA-4850-150, manufactured by DIC Corporation) and 0.2 g of 2-ethyl-4-methylimidazole (2E4MZ, manufactured by Shikoku Chemicals Corporation) were added and further kneaded.

Measurement results of the viscosity and the thermal conductivity after curing of the obtained curable resin composition are shown in Table 1.

(Example 5)

A uniform solution was obtained by mixing 10 g of bisphenol A type epoxy resin (EXA-4850-150, manufactured by DIC Corporation), 0.2 g of 2-ethyl-4-methylimidazole (2E4MZ, manufactured by Shikoku Chemicals Corporation) and 0.25 g of acidic phosphate ester (Phosphanol RA-600, manufactured by TOHO Chemical Industry Co., Ltd.). To the resultant solution, 25 g of aluminum nitride particles (Grade H, manufactured by Tokuyama Corporation) was added and kneaded.

Measurement results of the viscosity and the thermal conductivity after curing of the obtained curable resin composition are shown in Table 1.

(Example 6)

A uniform solution was obtained by mixing 10 g of bisphenol A type epoxy resin (EXA-4850-150, manufactured by DIC Corporation), 0.2 g of 2-ethyl-4-methylimidazole (2E4MZ, manufactured by Shikoku Chemicals Corporation) and 0.25 g of acidic phosphate ester (Phosphanol RA-600, manufactured by TOHO Chemical Industry Co., Ltd.). To the obtained solution, 30 g of aluminum nitride particles (Grade F, BET specific surface area: 3.4 $m^2/g$, manufactured by Tokuyama Corporation) was added and kneaded.

Measurement results of the viscosity and the thermal conductivity after curing of the obtained curable resin composition are shown in Table 1.

(Example 7)

A uniform solution was obtained by mixing 7.7 g of bishphenol F epoxy resin (EXA-830CRP, manufactured by DIC Corporation), 2.3 g of polyamine curing agent (JER Cure 113, manufactured by Mitsubishi Chemical Corporation) and 0.3 g of acidic phosphate ester (Phosphanol GF-199, manufactured by TOHO Chemical Industry Co., Ltd.). To the resultant solution, 35 g of aluminum nitride particles (Grade UM, BET specific surface area: 1.1 $m^2/g$, manufactured by TOYO ALUMINIUM K.K.) was added and kneaded.

Measurement results of the viscosity and the thermal conductivity after curing of the obtained curable resin composition are shown in Table 2.

(Example 8)

A uniform solution was obtained by mixing 5 g of bispenol F epoxy resin (EXA-830CRP, manufactured by DIC Corporation), 5 g of acid anhydride (B-570, manufactured by DIC Corporation), 0.8 g of N, N-dimethylbenzylamine (manufactured by Wako Pure Chemical Industries, Ltd.) as a promoter and 0.1 g of acidic phosphate ester (Phosphanol ML-200, manufactured by TOHO Chemical Industry Co., Ltd.). To the resultant solution, 40 g of aluminum nitride particles (Grade JD, BET specific surface area: 2.2 $m^2/g$, manufactured by TOYO ALUMINIUM K.K.) was added and kneaded.

Measurement results of the viscosity and the thermal conductivity after curing of the obtained curable resin composition are shown in Table 2.

(Example 9)

A uniform solution was obtained by mixing 10 g of bisphenol A type epoxy resin (EXA-4850-150, manufactured by DIC Corporation), 0.2 g of 2-ethyl-4-methylimidazole (2E4MZ, manufactured by Shikoku Chemicals Corporation) and 0.1 g of acidic phosphate ester (Phosphanol ML-200, manufactured by TOHO Chemical Industry Co., Ltd.). To the resultant solution, 30 g of aluminum nitride particles (Grade JD, manufactured by TOYO ALUMINIUM K.K.) and boron nitride (HCPL, BET specific surface area: 7 $m^2/g$, manufactured by Momentive Performance Materials Inc.) were added and kneaded.

Measurement results of the viscosity and the thermal conductivity after curing of the obtained curable resin composition are shown in Table 2.

(Example 10)

A uniform solution was obtained by mixing 10 g of bisphenol F type epoxy resin (EXA-830CRP, manufactured by DIC Corporation), 5 g of acid anhydride (B-570, manufactured by DIC Corporation), 0.8 g of N,N-dimethylbenzylamine (manufactured by Wako Pure Chemical Industries, Ltd.) as a promoter and 0.1 g of acidic phosphate ester (Phosphanol BH-650, manufactured by TOHO Chemical Industry Co., Ltd.). To the resultant solution, 40 g of aluminum nitride particles (Grade JD, manufactured by TOYO ALUMINIUM K.K.) was added and kneaded.

Measurement results of the viscosity and the thermal conductivity after curing of the obtained curable resin composition are shown in Table 2.

(Example 11)

A uniform solution was obtained by mixing 10 g of bisphenol F epoxy resin (EXA-830CRP, manufactured by DIC Corporation), 0.2 g of 2-ethyl-4-methylimidazole (2E4MZ, manufactured by Shikoku Chemicals Corporation), 0.5 g of octyl isocyanate (manufactured by Wako Pure Chemical Industries, Ltd.) and 0.22 g of acidic phosphate ester (Phosphanol RS-610, manufactured by TOHO Chemical Industry Co., Ltd.). To the resultant solution, 30 g of aluminum nitride particles (Grade H, manufactured by Tokuyama Corporation) was added and kneaded.

Measurement results of the viscosity and the thermal conductivity after curing of the obtained curable resin composition are shown in Table 2.

(Example 12)

A uniform solution was obtained by mixing 8 g of bisphenol F type epoxy resin (EXA-830CRP, manufactured by DIC Corporation), 0.2 g of 2-ethyl-4-methylimidazole (2E4MZ, manufactured by Shikoku Chemicals Corporation), 2 g of carbodiimide (Carbodilite V-05, manufactured by Nisshinbo Chemical Inc.) and 0.25 g of acidic phosphate ester (Phosphanol RS-610, manufactured by TOHO Chemical Industry Co., Ltd.). To the resultant solution, 40 g of aluminum nitride particles (Grade H, manufactured by Tokuyama Corporation) was added and kneaded.

Measurement results of the viscosity and the thermal conductivity after curing of the obtained curable resin composition are shown in Table 2.

(Example 13)

A uniform solution was obtained by mixing 10 g of bisphenol F type epoxy resin (EXA-830CRP, manufactured by DIC Corporation), 0.2 g of 2-ethyl-4-methylimidazole (2E4MZ, manufactured by Shikoku Chemicals Corporation), 0.1 g of acethylacetone aluminium (manufactured by Tokyo Chemical Industry Co., Ltd.) and 0.22 g of acidic phosphate ester (Phosphanol RS-610, manufactured by TOHO Chemical Industry Co., Ltd.). To the resultant solution, 40 g of aluminum nitride particles (Grade H, manufactured by Tokuyama Corporation) was added and kneaded.

Measurement results of the viscosity and the thermal conductivity after curing of the obtained curable resin composition are shown in Table 2.

(Storage stability)

An accelerated test of storage stability was carried out by leaving the curable resin compositions of Examples 2 and 13 standing at 40°C for 48 hours. The curable resin composition of Example 2 cured whereas the curable resin composition of Example 13 did not cure. Although the reason for this is not clearly figured out, it is presumed that the curable resin composition of Example 2 cured probably because there existed strongly Lewis basic sites on the surface of the aluminum nitride, which negatively affected the stability of the epoxy resin, whereas the curable resin composition of Example 13 did not cure because the basic sites were neutralized by acetylacetone aluminium which is a Lewis acid.

(Example 14)

A uniform solution was obtained by heating 1 kg of aluminum nitride particles (particle diameter: 1.1 μm, BET specific surface area: 1.6 $m^2$, an article made on an experimental basis by Tokuyama Corporation), 4.0 g of solution of aluminum phosphate (100 L, $Al_2O_3$/8.5%, $P_2O_5$/33.0%, manufactured by TAKI CHEMICAL CO., LTD.), 3.0 g of lauryl phosphate ester (ML-200 manufactured by TOHO Chemical Industry Co., Ltd.) and 1 kg of water, and the resultant mixture was subjected to three times of treatments with an ultrasonic disperser (GSD600HAT, manufactured by Ginsen Co., Ltd.), dried by means of a spray dryer (R-100, manufactured by PRECI CO., LTD.) with an entrance temperature of 200°C, and then dried in vacuo at 80°C for 15 hours. The obtained particles were named as aluminum nitride particles A.

A uniform solution was obtained by heating 1 kg of aluminum nitride particles (particle diameter: 4.5 μm, BET specific surface area: 0.6 $m^2$, an article made on an experimental basis by Tokuyama Corporation), 2.5 g of solution of aluminum phosphate (100 L, $Al_2O_3$/8.5%, $P_2O_5$/33.0%, manufactured by TAKI CHEMICAL CO., LTD.), 1.5 g of lauryl phosphate ester (ML-200, manufactured by TOHO Chemical Industry Co., Ltd.) and 1 kg of water, and the resultant mixture was subjected to three times of treatments with an ultrasonic disperser (GSD600HAT, manufactured by Ginsen Co., Ltd.), dried by means of a spray dryer (R-100, manufactured by PRECI CO., LTD.) with an entrance temperature of 200°C, and then dried in vacuo at 80°C for 15 hours. The obtained particles were named as aluminum nitride particles B.

A uniform solution was obtained by 10 g of bisphenol F type epoxy resin (EXA-830CRP, manufactured by DIC Corporation), 0.2 g of 2-ethyl-4-methylimidazole (2E4MZ, manufactured by Shikoku Chemicals Corporation), and 0.25 g of acidic phosphate ester (Phosphanol RA-600, manufactured by TOHO Chemical Industry Co., Ltd.). To the resultant solution, 20 g of the aluminum nitride particles A and 30 g of the aluminum nitride particles B were added and kneaded.
Measurement results of the viscosity and the thermal conductivity after curing of the obtained curable resin composition are shown in table 3.

(Example 15)

Acidic phosphate ester (Phosphanol RA-600, manufactured by TOHO Chemical Industry Co., Ltd.) in an amount of 0.25 g was dissolved in 2 g of bisphenol F type epoxy resin (EXA-830CRP, manufactured by DIC Corporations) and kneaded with 45 g of the aluminum nitride particles A. To the resultant mixture, a uniform solution of 8 g of bisphenol F type epoxy resin (EXA-830CRP, manufactured by DIC Corporation) and 0.2 g of 2-ethyl-4-methylimidazole (2E4MZ, manufactured by Shikoku Chemicals Corporation) was added and further kneaded.
Measurement results of the viscosity and the thermal conductivity after curing of the obtained curable resin composition are shown in Table 3.

(Example 16)

Acidic phosphate ester (Phosphanol RA-600, manufactured by TOHO Chemical Industry Co., Ltd.) in an amount of 0.25 g was dissolved in 2 g of bisohenol F epoxy resin (EXA-830CRP, manufactured by DIC Corporation) and kneaded with 30 g of the aluminum nitride particles A and 20 g of the aluminum nitride particles B. The resultant mixture was kept at a temperature of 40°C for 8 hours, thereafter a uniform mixture of 8 g of bisphenol F type epoxy resin (EXA-830CRP, manufactured by DIC Corporation) and 0.2 g of 2-ethyl-4-methylimidazole (2E4MZ, manufactured by Shikoku Chemicals Corporation) was added and further kneaded.
Measurement results of the viscosity and the thermal conductivity after curing of obtained curable resin composition are shown in Table 3.

(Example 17)

A uniform solution was obtained by mixing 10 g of bisphenol F type epoxy resin (EXA-830CRP, manufactured by DIC Corporation), 0.2 g of 2-ethyl-4-methylimidazole (2E4MZ, manufactured by Shikoku Chemicals Corporation) and 0.07 g of acidic phosphate ester (Phosphanol RS-610, manufactured by TOHO Chemical Industry Co., Ltd.). To the resultant solution, 30 g of aluminum nitride particles (Grade H, an article made on an experimental basis by Tokuyama Corporation) was added and kneaded.
Measurement results of the viscosity and the thermal conductivity after curing of the obtained curable resin composition are shown in Table 3.

(Example 18)

A uniform solution was obtained by mixing 10 g of bisphenol F type epoxy resin (EXA-830CRP, manufactured by DIC Corporation), 0.2 g of 2-ethyl-4-methylimidazole (2E4MZ, manufactured by Shikoku Chemicals Corporation) and 0.03 g of acidic phosphate ester (Phosphanol RS-610, manufactured by TOHO Chemical Industry Co., Ltd.). To the resultant solution, 25 g of aluminum nitride particles (Grade H, manufactured by Tokuyama Corporation) and 25 g of alumina particles (AKP-20, BET specific surface area: 5$m^2$/g, manufactured by Sumitomo Chemical Co., Ltd.) were added and kneaded.
Measurement results of the viscosity and the thermal conductivity after curing of the obtained curable resin composition are shown in Table 3.

(Example 19)

A uniform solution was obtained by mixing 10 g of bisphenol F type epoxy resin (EXA-830CRP, manufactured by DIC Corporation), 0.2 g of 2-ethyl-4-methylimidazole (2E4MZ, manufactured by Shikoku Chemicals Corporation) and 0.03 g of acidic phosphate ester (Phosphanol RS-610, manufactured by TOHO Chemical Industry Co., Ltd.). To the resultant solution, 12 g of aluminum nitride particles (Grade H, manufactured by Tokuyama Corporation) and boron nitride particles (HCPL, BET specific surface area: 7 $m^2$/g, manufactured by Momentive Performance Materials Inc.) were added and kneaded.
Measurement results of the viscosity and the thermal conductivity after curing of the obtained curable resin

composition are shown in Table 3.

(Example 20)

A uniform solution was obtained by mixing 10 g of bisphenol F type epoxy resin (EXA-830CRP, manufactured by DIC Corporation), 0.2 g of 2-ethyl-4-methylimidazole (2E4MZ, manufactured by Shikoku Chemicals Corporation) and 0.25 g of acidic phosphate ester (BYK-W9010, manufactured by BYK-Chemie Japan). To the resultant solution, 40 g of aluminum nitride particles (Grade H, manufactured by Tokuyama Corporation) were added and kneaded.
Measurement results of the viscosity and the thermal conductivity after curing of the obtained curable resin composition are shown in Table 3.

(Comparative Example 2)

A uniform solution was obtained by mixing 5 g of bisphenol A type epoxy resin (JER1004, manufactured by Mitsubishi Chemical Corporation), 5g of o-cresol novolac type epoxy resin (YDCN703, manufactured by Tohto Chemical Industry Co., Ltd) and 0.2 g of 1-cyanoethyl-2-phenylimidazolium trimellitate (2PZCN-PW, manufactured by Shikoku Chemicals Corporation). To the resultant solution, 35 g of aluminum nitride particles (Grade H, manufactured by Tokuyama Corporation) were added and kneaded.
Measurement results of the viscosity and the thermal conductivity after curing of the obtained curable resin composition are shown in Table 4.

(Comparative Example 3)

A uniform solution was obtained by mixing 10 g of bisphenol F type epoxy resin (EXA-830CRP, manufactured by DIC Corporation), 0.2 g of 2-ethyl-4-methylimidazole (2E4MZ, manufactured by Shikoku Chemicals Corporation) and 0.25 g of acidic phosphate ester (a mixture of monoisopropyl phosphate and diisopropyl phosphate, A-3, manufactured by SC Organic Chemical Co., Ltd.). To the resultant solution, 40 g of aluminum nitride particles (Grade H, manufactured by Tokuyama Corporation) were added and kneaded.
Measurement results of the viscosity and the thermal conductivity after curing of the obtained curable resin composition are shown in Table 4.

(Comparative Example 4)

A uniform solution was obtained by mixing 10 g of bisphenol F type epoxy resin (EXA-830CRP, manufactured by DIC Corporation), 0.2 g of 2-ethyl-4-methylimidazole (2E4MZ, manufactured by Shikoku Chemicals Corporation) and 0.25 g of lauric acid (manufactured by Tokyo Chemical Industry Co., Ltd.). To the resultant solution, 40 g of aluminum nitride particles (Grade H, manufactured by Tokuyama Corporation) were added and kneaded.
Measurement results of the viscosity and the thermal conductivity after curing of the obtained curable resin composition are shown in Table 4.

(Comparative Example 5)

A uniform solution was prepared by mixing 10 g of bisphenol F type epoxy resin (EXA-830CRP, manufactured by DIC Corporation), 0.2 g of 2-ethyl-4-methylimidazole (2E4MZ, manufactured by Shikoku Chemicals Corporation) and 0.25 g of tetraethylene glycol lauryl ether (Pegnol L-4, manufactured by TOHO Chemical Industry Co., Ltd.). To the resultant solution, 40 g of aluminum nitride particles (Grade H, manufactured by Tokuyama Corporation) were added and kneaded.
Measurement results of the viscosity and the thermal conductivity after curing of the obtained curable resin composition are shown in Table 4.

(Comparative Example 6)

A uniform solution was obtained by mixing 10 g of bisphenol F type epoxy resin (EXA-830CRP, manufactured by DIC Corporation), 0.2 g of 2-ethyl-4-methylimidazole (2E4MZ, manufactured by Shikoku Chemicals Corporation) and 0.25 g of acidic phosphate ester (Phosphanol RS-610, manufactured by TOHO Chemical Industry Co., Ltd.). To the resultant solution, 40 g of alumina particles (AKP-20, BET specific surface area: 5 $m^2/g$, manufactured by Sumitomo Chemical Co., Ltd.) were added and kneaded.
Measurement results of the viscosity and the thermal conductivity after curing of the obtained curable resin

composition are shown in Table 4.

(Comparative Example 7)

A uniform solution was obtained by mixing 10 g of bisphenol F type epoxy resin (EXA-830CRP, manufactured by DIC Corporation), 0.2 g of 2-ethyl-4-methylimidazole (2E4MZ, manufactured by Shikoku Chemicals Corporation) and 0.25 g of ethyl carbitol (manufactured by Tokyo Chemical Industry Co., Ltd.). To the resultant solution, 40 g of aluminum nitride particles (Grade H, manufactured by Tokuyama Corporation) were added and kneaded.
Measurement results of the viscosity and the thermal conductivity after curing of the obtained curable resin composition are shown in Table 4.

(Comparative Example 8)

A uniform solution was obtained by mixing 10 g of bisphenol F type epoxy resin (EXA-830CRP, manufactured by DIC Corporation), 0.2 g of 2-ethyl-4-methylimidazole (2E4MZ, manufactured by Shikoku Chemicals Corporation) and 0.03 g of acidic ester not having acid group ($[(CH_3)_2C_6H_3O]_2P(O)OC_6H_4OP(O)[OC_6H_3(CH_3)_2]_2$, PX-200, manufactured by DAIHACHI CHEMICAL INDUSTORY, CO., LTD.). To the resultant solution, 12 g of aluminum nitride particles (Grade H, manufactured by Tokuyama Corporation) and boron nitride particles (HCPL, BET specific surface area: 7 $m^2/g$, manufactured by Momentive Performance Materials Inc.) were added and kneaded.
Measurement results of the viscosity and the thermal conductivity after curing of the obtained curable resin composition are shown in Table 4.

<Examples 21 to 28 and Comparative Examples 9 to 11>

The followings are examples in which the high thermal conductive laminated substrates according to the fourth aspect of the present invention were manufactured and comparative examples in which manufacturing of high thermal conductive laminated substrate was tried.

(Example 21)

A high thermal conductive laminated substrate was obtained by: thinly applying the curable resin composition of Example 9 to an electrolytic copper foil (JTC: manufactured by JX Nippon Mining & Metals Corporation) having a thickness of 18 μm; disposing an aluminum substrate (A1050, thickness: 1 mm, thermal conductivity: 225 W/m·K: manufactured by Okouchi Kinzoku Co., Ltd.) to the coated surface of the electrolytic copper foil; thereafter carrying out a vacuum press at 180°C for 3 hours.
The adhesive strength and the withstand voltage of the obtained high thermal conductive laminated substrate and the theoretical calculation value of the thermal conductivity of the composite layer consisting of the high thermal conductive resin and the aluminum substrate are shown in Table 5.

(Example 22)

A high thermal conductive laminated substrate was obtained by: preparing a primer solution by mixing 10 g of bisphenol F type epoxy resin (EXA-830CRP: manufactured by DIC Corporation), 0.2 g of 2-ethyl-4-methylimidazole (2E4MZ: manufactured by Shikoku Chemicals Corporation), 10 g of an acidic phosphate ester (Phsphanol RS-610, manufactured by TOHO Chemical Industry Co., Ltd.), and 100 g of toluene; applying the primer solution onto an aluminum substrate (A1050, thickness: 1 mm, manufactured by Okouchi Kinzoku co., Ltd.) by spin coating, followed by drying at 120°C for 1 hour; thinly applying the curable resin composition of Example 14 onto a rolled copper foil (HPF-ST35-X, manufactured by Hitachi Densen shoji, Ltd.) having a thickness of 35 μm; placing the applied surface of the primer of the aluminum substrate on the surface of the rolled copper foil where the curable resin composition of Example 14 was applied; thereafter carrying out a vacuum press at 180°C for 3 hours.
The adhesive strength and the withstand voltage of the obtained high thermal conductive laminated substrate and the theoretical calculation value of the thermal conductivity of the composite layer consisting of the high thermal conductive resin and the aluminum substrate are shown in Table 5.

(Example 23)

A high thermal conductive laminated substrate was obtained by : thinly applying the curable resin composition of Example 16 onto an electrolytic copper foil (JTC, manufactured by JX Nippon Mining & Metals Corporation) having

a thickness of 12 μm; placing an aluminum substrate (A1050, a thickness of 0.5 mm, manufactured by Okouchi Kinzoku co., ltd.) onto the applied surface of the copper foil; thereafter carrying out a vacuum press at 180°C for 3 hours.

The adhesive strength and the withstand voltage of the obtained high thermal conductive laminated substrate and the theoretical calculation value of the thermal conductivity of the composite layer consisting of the high thermal conductive resin and the aluminum substrate are shown in Table 5.

(Example 24)

A high thermal conductive laminated substrate was obtained by: thinly applying the curable resin composition of Example 3 onto an electrolytic copper foil (JTC: manufactured by JX Nippon Mining & Metals Corporation) having a thickness of 12 μm: placing an aluminum nitride substrate (thickness: 0.64 mm, thermal conductivity: 170 W/m · K, manufactured by TD Power material) on the applied surface of the copper foil; thereafter carrying out a vacuum press at 180°C for 3 hours.

The adhesive strength and the withstand voltage of the obtained high thermal conductive laminated substrate and the theoretical calculation value of the thermal conductivity of the composite layer consisting of the high thermal conductive resin and the aluminum nitride substrate are shown in Table 5.

(Example 25)

A high thermal conductive laminated substrate was obtained by: thinly applying the curable resin composition of Example 8 onto an electrolytic copper foil (JTC, manufactured by JX Nippon Mining & Metal Corporation) having a thickness of 9 μm; placing an aluminum nitride substrate (thickness: 1 mm, manufactured by TD Power material) on the applied surface of the copper foil; thereafter carrying out a vacuum press at 180°C for 3 hours.

The adhesive strength and the withstand voltage of the obtained high thermal conductive laminated substrate and the theoretical calculation value of the thermal conductivity of the composite layer consisting of the high thermal conductive resin and the aluminum nitride substrate are shown in Table 5.

(Example 26)

A high thermal conductive laminated substrate was obtained by: thinly applying the curable resin composition of Example 13 onto an electrolytic copper foil (JTC: manufactured by JX Nippon Mining & Metal Corporation) having a thickness of 18 μm; placing an aluminum nitride substrate (thickness: 1mm, manufactured by TD Power Material) on the applied surface of the copper foil; thereafter carrying out a vacuum press at 180°C for 3 hours.

The adhesive strength and the withstand voltage of the obtained high thermal conductive laminated substrate and the theoretical calculation value of the thermal conductivity of the composite layer consisting of the high thermal conductive resin and the aluminum nitride substrate are shown in Table 5.

(Example 27)

A high thermal conductive laminated substrate was obtained by: thinly applying the curable resin composition of Example 14 onto an electrolytic copper foil (JTC: manufactured by JX Nippon Steel & Mining Corporation) having a thickness of 18 μm; placing an aluminum substrate (A1050, a thickness of 1 mm: manufactured by Okouchi Kinzoku co., ltd.) on the applied surface of the copper foil; thereafter carrying out vacuum press at 180°C for 3 hours.

The adhesive strength and the withstand voltage of the obtained high thermal conductive laminated substrate and the theoretical calculation value of the thermal conductivity of the composite layer consisting of the high thermal conductive resin and the aluminum substrate are shown in Table 5.

(Example 28)

A high thermal conductive laminated substrate was obtained by: thinly applying the curable resin composition of Example 4 onto an electrolytic copper foil (JTC: manufactured by JX Nippon Steel & Mining Corporation) having a thickness of 18 μm: placing an aluminum nitride substrate (thickness: 1 mm, manufactured by TD Power Material) on the applied surface of the copper foil; thereafter carrying out a vacuum press at 180°C for 3 hours.

The adhesive strength and the withstand voltage of the obtained high thermal conductive laminated substrate and the theoretical calculation value of the thermal conductivity of the composite layer consisting of the high thermal conductive resin and the aluminum substrate are shown in Table 5.

(Comparative Example 9)

A laminated substrate was obtained by: thinly applying the curable resin composition of Comparative Example 5 onto an electrolytic copper foil (JTC, manufactured by JX Nippon Mining & Metal Corporation) having a thickness of 18 μm; placing an aluminum substrate to the applied surface of the copper foil (A1050, thickness: 1 mm, manufactured by Okouchi Kinzoku co., ltd.); thereafter carrying out a vacuum press at 180°C for 3 hours.
The adhesive strength and the withstand voltage of the obtained high thermal conductive laminated substrate and the theoretical calculation value of the thermal conductivity of the composite layer consisting of the resin composition layer and the aluminum substrate are shown in Table 6.

(Comparative Example 10)

A laminated substrate was obtained by: thinly applying the curable resin composition of Comparative Example 5 onto an electrolytic copper foil (JTC: manufactured by JX Nippon Mining & Metal Corporation) having a thickness of 35 μm; placing an aluminum nitride substrate (thickness: 1 mm, manufactured by TD Power Material) to the applied surface of the copper foil; thereafter carrying out a vacuum press at 180°C for 3 hours.
The adhesive strength and the withstand voltage of the obtained high thermal conductive laminated substrate and the theoretical calculation value of the thermal conductivity of the composite layer consisting of the resin composition layer and the aluminum nitride substrate are shown in Table 6.

(Comparative Example 11)

A laminated substrate was obtained by: thinly applying the curable resin composition of Comparative Example 4 onto an electrolytic copper foil (JTC, manufactured by JX Nippon Mining & Metal Corporation) having a thickness of 12 μm; placing an aluminum nitride substrate (thickness: 1 mm, manufactured by TD Power Material) to the applied surface of the copper foil; thereafter carrying out a vacuum press at 180°C for 3 hours.
The adhesive strength and the withstand voltage of the obtained high thermal conductive laminated substrate and the theoretical calculation value of the thermal conductivity of the composite layer consisting of the resin composition layer and the aluminum nitride substrate are shown in Table 6.

[Table 1]

| | | Example 1 | Example 2 | Example 3 | Comparative Example 1 | Example 4 | Example 5 | Example 6 |
|---|---|---|---|---|---|---|---|---|
| Epoxy resin | constituent | Bisphenol A type 1004 | Bisphenol F type EXA-830CRP | Bisphenol F type EXA-830CRP | Bisphenol F type EXA-830CRP | Bisphenol A type EXA-4850-150 | Bisphenol A type EXA-4850 | Bisphenol A type EXA-4850 |
| | amount | 6.0g | 10.0g | 10.0g | 10.0g | 10.0g | 10.0g | 10.0g |
| | constituent | Cresol novolac type YDCN703 | - | - | - | - | - | - |
| | amount | 4.0g | - | - | - | - | - | - |
| Curing agent | constituent | Imidazole 2PZCN-PW | Imidazole 2E4MZ | Imidazole 2E4MZ | Imidazole 2E4MZ | Imidazole 2PZCN-PW | Imidazole 2E4MZ | Imidazole 2E4MZ |
| | amount | 0.2g | 0.2g | 0.2g | 0.2g | 0.2g | 0.2g | 0.2g |
| Filler | constituent | Aluminum nitride Grade H | Aluminum nitride Grade H | Aluminum nitride Grade H | Aluminum nitride Grade H (surface-treated) | Aluminum nitride Grade H | Aluminum nitride Grade H | Aluminum nitride Grade F |
| | amount | 35.0g | 45.0g | 40.0g | 40.0g | 20.0g | 25.0g | 30.0g |
| | constituent | - | - | - | | Alumina DAW-45 | - | - |
| | amount | - | - | - | | 30.0g | - | - |
| Phosphoric acid ester | constituent | PHOSPHANOL RS-410 | PHOSPHANOL RS-610 | PHOSPHANOL RA-600 | PHOSPHANOL RA-600 (surface-treated) | PHOSPHANOL RS-710 | PHOSPHANOL RA-600 | PHOSPHANOL RA-600 |
| | amount | 0.1g | 0.3g | 0.2g | equivalentto 0.2g | 0.35g | 0.25g | 0.25g |
| Other | constituent | - | - | - | - | - | - | - |
| | amount | - | - | - | - | - | - | - |
| Viscosity | (Pa·s) | 2800 | 2100 | 1300 | 2700 | 5700 | 2900 | 4100 |
| Thermal conductivity | (W/m·K) | 6.7 | 7.9 | 8.3 | 4.9 | 5.3 | 5.1 | 6.8 |

[Table 2]

| | | Example 7 | Example 8 | Example 9 | Example 10 | Example 11 | Example 12 | Example 13 |
|---|---|---|---|---|---|---|---|---|
| Epoxy resin | constituent | Bisphenol F type EXA-830CRP | Bisphenol F type EXA-830CRP | Bisphenol A type EXA-4850-150 | Bisphenol F type EXA-830CRP | Bisphenol F type EXA-830CRP | Bisphenol F type EXA-830CRP | Bisphenol F type EXA-830CRP |
| | amount | 7.7g | 5.0g | 10.0g | 5.0g | 10.0g | 8.0g | 10.0g |
| | constituent | - | - | - | - | - | - | - |
| | amount | - | - | - | - | - | - | - |
| Curing agent | constituent | Polyamine 113 | Acid anhydride B-570 | Imidazole 2E4MZ | Acid anhydride B-570 | Imidazole 2E4MZ | Imidazole 2E4MZ | Imidazole 2E4MZ |
| | amount | 2.3g | 5.0g | 0.2g | 5.0g | 0.2g | 0.2g | 0.2g |
| Filler | constituent | Aluminum nitride Grade UM | Aluminum nitride Grade JD | Aluminum nitride Grade JD | Aluminum nitride Grade JD | Aluminum nitride Grade H | Aluminum nitride Grade H | Aluminum nitride Grade H |
| | amount | 35.0g | 40.0g | 30.0g | 40.0g | 40.0g | 40.0g | 40.0g |
| | constituent | - | - | Boron nitride | - | - | - | - |
| | amount | - | - | 10.0g | - | - | - | - |
| Phosphoric acid ester | constituent | PHOSPHANOL GF-199 | PHOSPHANOL ML-200 | PHOSPHANOL ML-220 | PHOSPHANOL RS-410 | PHOSPHANOL RS-610 | PHOSPHANOL RS-610 | PHOSPHANOL RS-610 |
| | amount | 0.3g | 0.1g | 0.1g | 0.1g | 0.22g | 0.25g | 0.22g |
| Other | constituent | - | - | - | - | Octyl isocyanate | Carbodiimide | Acelylacetone aluminium |
| | amount | - | - | - | - | 0.5g | 2.0g | 0.1g |
| Viscosity (Pa·s) | | 3200 | 1100 | 6600 | 3400 | 1200 | 1600 | 1400 |
| Thermal (W/m·K) conductivity | | 5.4 | 5.9 | 6.5 | 5.3 | 7.9 | 7.7 | 8.0 |

[Table 3]

| | | Example 14 | Example 15 | Example 16 | Example 17 | Example 18 | Example 19 | Example 20 |
|---|---|---|---|---|---|---|---|---|
| Epoxy resin | constituent | Bisphenol A type EXA-4850 | Bisphenol A type EXA-4850 | Bisphenol A type EXA-4850 | Bisphenol F type EXA-830CRP | Bisphenol F type EXA-830CRP | Bisphenol F type EXA-830CRP | Bisphenol F type EXA-830CRP |
| | amount | 10.0g | 10.0g | 10.0g | 10.0g | 10.0g | 10.0g | 10.0g |
| | constituent | - | - | - | - | - | - | - |
| | amount | - | - | - | - | - | - | - |
| Curing agent | constituent | Imidazole 2E4MZ | Imidazole 2E4MZ | Imidazole 2E4MZ | Imidazole 2E4MZ | Imidazole 2E4MZ | Imidazole 2E4MZ | Imidazole 2E4MZ |
| | amount | 0.2g | 0.2g | 0.2g | 0.2g | 0.2g | 0.2g | 0.2g |
| Filler | constituent | Aluminum nitride, 1.1μm (surface-treated) | Aluminum nitride, 1.1μm (surface-treated) | Aluminum nitride, 1.1μm (surface treated) | Aluminum nitride Grade H | Aluminum nitride Grade H | Aluminum nitride Grade H | Aluminum nitride Grade H |
| | amount | 20.0g | 45.0g | 30.0g | 40.0g | 25.0g | 12.0g | 40.0g |
| | constituent | Aluminum nitride, 4.5μm (surface-treated) | - | Aluminum nitride, 4.5 μm (surface-treated) | - | Alumina AKP-20 | Boron nitride HCPL | |
| | amount | 30.0g | - | 20.0g | - | 25.0g | 25.0g | |
| Phosphoric acid ester | constituent | PHOSPHANOL RA-600 | PHOSPHANOL RA-600 | PHOSPHANOL RA-600 | PHOSPHANOL RS-610 | PHOSPHANOL RS-610 | PHOSPHANOL RS-610 | BYK-W9010 |
| | amount | 0.25g | 0.25g | 0.25g | 0.07g | 0.25g | 0.25g | 0.25g |
| Other | constituent | - | - | - | - | - | - | - |
| | amount | - | - | - | - | - | - | - |
| Viscosity (Pa·s) | | 5500 | 1400 | 6700 | 7900 | 6900 | 8200 | 2300 |
| Thermal (W/m·K) conductivity | | 9.2 | 8.8 | 9.7 | 4.3 | 4.1 | 4.7 | 4.5 |

[Table 4]

| | | Comparative Example 2 | Comparative Example 3 | Comparative Example 4 | Comparative Example 5 | Comparative Example 6 | Comparative Example 7 | Comparative Example 8 |
|---|---|---|---|---|---|---|---|---|
| Epoxy resin | constituent | Bisphenol A type 1004 | Bisphenol F type EXA-830CRP | Bisphenol F type EXA-830CRP | Bisphenol F type EXA-830CRP | Bisphenol F type EXA-830CRP | Bisphenol F type EXA-830CRP | Bisphenol F type EXA-830CRP |
| | amount | 5.0g | 10.0g | 10.0g | 10.0g | 10.0g | 10.0g | 10.0g |
| | constituent | Cresol novolac type YDCN703 | - | - | - | - | - | - |
| | amount | 5.0g | - | - | - | - | - | - |
| Curing agent | constituent | Imidazole 2PZCN-PW | Imidazole 2E4MZ | Imidazole 2E4MZ | Imidazole 2E4MZ | Imidazole 2E4MZ | Imidazole 2E4MZ | Imidazole 2E4MZ |
| | amount | 0.2g | 0.2g | 0.2g | 0.2g | 0.2g | 0.2g | 0.2g |
| Filler | constituent | Aluminum nitride Grade H | Aluminum nitride Grade H | Aluminum nitride Grade H | Aluminum nitride Grade H | Alumina AKP-20 | Aluminum nitride Grade H | Aliminum nitride Grade H |
| | amount | 35.0g | 40.0g | 40.0g | 40.0g | 40.0g | 40.0g | 40.0g |
| | constituent | - | - | - | - | - | - | - |
| | amount | - | - | - | - | - | - | - |
| Phosphoric acid ester | constituent | - | A-3 | Lauric acid | Pegnol L-4 | PHOSPHANOL RS-610 | - | PX-200 |
| | amount | - | 0.25g | 0.25g | 0.25g | 0.25g | - | 0.25g |
| Other | constituent | - | - | - | - | - | Ethyl carbitol | - |
| | amount | - | - | - | - | - | 0.25g | - |
| Viscosity (Pa·s) | | 9700 | 8500 | 8100 | 8300 | 1700 | 8300 | 8900 |
| Thermal conductivity (W/m·K) conductivity | | 3.5 | 3.8 | 3.5 | 3.3 | 2.2 | 3.6 | 3.5 |

[Table 5]

| | | Example 21 | Example 22 | Example 23 | Example 24 | Example 25 | Example 26 | Example 27 | Example 28 |
|---|---|---|---|---|---|---|---|---|---|
| Substrate | material | Aluminium | Aluminium | Aluminium | Aluminum nitride | Aluminum nitride | Aluminum nitride | Aluminium | Aluminum nitride |
| | thickness (mm) | 1.00 | 1.00 | 0.50 | 0.64 | 1.00 | 1.00 | 1.00 | 1.00 |
| Curable resin composition | | Example 9 | Example 14 | Example 16 | Example 3 | Example 8 | Example 13 | Example 14 | Example 4 |
| High thermal conductive resin composition layer | thickness (μm) | 120 | 160 | 90 | 6 | 3 | 9 | 410 | 26 |
| Copper foil | thickness (μm) | 18 | 35 | 12 | 12 | 9 | 18 | 18 | 18 |
| Adhesive strength | (MPa) | 25 | 18 | 32 | 22 | 20 | 26 | 15 | 23 |
| Insulation performance | | passed | passed | passed | passed | passed | passed | passed | passed |
| Thermal conductivity of composite layer | (W/m·K) | 49 | 53 | 51 | 144 | 157 | 144 | 132 | 28 |

[Table 6]

| | | Comparative Example 9 | Comparative Example 10 | Comparative Example 11 |
|---|---|---|---|---|
| Substrate | material | Aluminium | Aluminum | Aluminum |
| | thickness (mm) | 1.00 | 1.00 | 0.50 |
| Curable resin composition | | Comparative Example 5 | Comparative Example 5 | Comparative Example 4 |
| High thermal conductive resin composition layer | thickness (μm) | 110 | 140 | 230 |
| Copper foil | thickness (μm) | 18 | 35 | 12 |
| Adhesive strength | (MPa) | 22 | 21 | 17 |
| Insulation performance | | passed | passed | passed |
| Thermal conductivity of composite layer | (W/m·K) | 20 | 16 | 10 |

The above results show that use of the curable resin composition of the present invention makes it possible to manufacture a high thermal conductive laminated substrate having adhesive strength necessary and sufficient for practical use at reasonable cost.

Description of the Reference Numerals

1 metal or high thermal conductive ceramics substrate (substrate)
2 metallic foil
3 curable resin composition
4 high thermal conductive resin composition layer
5 composite layer
10 high thermal conductive laminated substrate (laminated substrate)

## Claims

**1.** A curable resin composition comprising:

aluminum nitride particles;
an epoxy resin;
a curing agent; and
an acidic phosphate ester represented by the following formula (1) :

$$[R_1O(COR_2O)_k(R_3O)_l(COR_4COO)_m]_n\overset{\displaystyle (OH)_{3-n}}{\overset{|}{P}}{=}O \qquad (1)$$

(In the formula (1),

$R_1$ represents a saturated or unsaturated hydrocarbyl group having a carbon number of 4 to 20;
$R_2$ represents a saturated hydrocarbylene group having a carbon number of 1 to 20;

$R_3$ represents a saturated hydrocarbylene group having a carbon number of 2 or 3;
$R_4$ represents a saturated or unsaturated hydrocarbylene group having a carbon number of 1 to 8;
k represents an integer of 0 to 20;
1 represents an integer of 0 to 20;
m represents an integer of 0 to 20; and
n represents an integer of 1 or 2, wherein
where a plurality of $R_1$ exist, the plurality of $R_1$ may be the same as or different from each other;
where a plurality of $R_2$ exist, the plurality of $R_2$ may be the same as or different from each other;
where a plurality of $R_3$ exist, the plurality of $R_3$ may be the same as or different from each other;
where a plurality of $R_4$ exist, the plurality of $R_4$ may be the same as or different from each other;
k-number of $-COR_2O-$ groups, 1-number of $-R_3O-$ groups, and m-number of $-COR_4COO-$ groups may be in any order; and
where n is 2, two $R_1O(COR_2O)_k(R_3O)_l(COR_4COO)_m$ groups may be the same as or different from each other.),
wherein the aluminum nitride particles, the epoxy resin, the curing agent, and the acidic phosphate ester are mixed with each other in the curable resin composition.

**2.** A method for manufacturing a curable resin composition comprising the step of:

mixing aluminum nitride particles, an epoxy resin, a curing agent, and an acidic phosphate ester represented by the following formula (1) with each other:

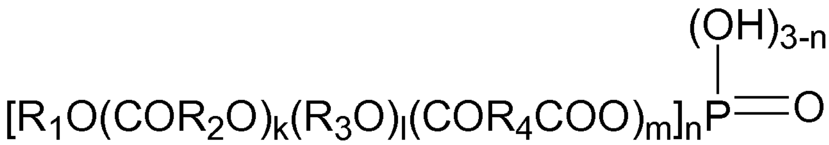

(1)

(In the formula (1),

$R_1$ represents a saturated or unsaturated hydrocarbyl group having a carbon number of 4 to 20;
$R_2$ represents a saturated hydrocarbylene group having a carbon number of 1 to 20;
$R_3$ represents a saturated hydrocarbylene group having a carbon number of 2 or 3;
$R_4$ represents a saturated or unsaturated hydrocarbylene group having a carbon number of 1 to 8;
k represents an integer of 0 to 20;
1 represents an integer of 0 to 20;
m represents an integer of 0 to 20; and
n represents an integer of 1 or 2, wherein
where a plurality of $R_1$ exist, the plurality of $R_1$ may be the same as or different from each other;
where a plurality of $R_2$ exist, the plurality of $R_2$ may be the same as or different from each other;
where a plurality of $R_3$ exist, the plurality of $R_3$ may be the same as or different from each other;
where a plurality of $R_4$ exist, the plurality of $R_4$ may be the same as or different from each other;
k-number of $-COR_2O-$ groups, 1-number of $-R_3O-$ groups, and m-number of $-COR_4COO-$ groups may be in any order; and
where n is 2, two $R_1O(COR_2O)_k(R_3O)_l(COR_4COO)_m$ groups may be the same as or different from each other.).

**3.** The method for manufacturing the curable resin composition according to claim 2, wherein the mixing step comprises the step of:

mixing the aluminum nitride particles with a mixture containing the acidic phosphate ester and all or a portion of the epoxy resin.

**4.** The method for manufacturing the curable resin composition according to claim 2 or 3, wherein the mixing step comprises the successive steps of:

(i) mixing the acidic phosphate ester and the epoxy resin; and
(ii) mixing the resultant mixture of the step (i), the aluminum nitride particles, and the curing agent.

5. The method for manufacturing the curable resin composition according to claim 2 or 3, wherein the mixing step comprises the successive steps of:

(i) mixing the acidic phosphate ester and a portion of the epoxy resin;
(ii) mixing the resultant mixture of the step (i) and the aluminum nitride particles; and
(iii) mixing the resultant mixture of the step (ii), the remaining portion of the epoxy resin, and the curing agent, and wherein the curing agent is a basic curing agent.

6. A high thermal conductive resin composition, which is obtainable by curing the curable resin composition according to claim 1.

7. A high thermal conductive laminated substrate comprising:

a metallic foil;
the high thermal conductive resin composition according to claim 6; and
a metal or high thermal conductive ceramic substrate,
wherein the metallic foil, the high thermal conductive resin composition according to claim 6, and the metal or high thermal conductive ceramic substrate, are layered in the order mentioned.

8. A method for manufacturing a high thermal conductive laminated substrate comprising the successive steps of:

layering a metallic foil and a metal or high thermal conductive ceramic substrate, wherein the curable resin composition according to claim 1 is disposed between the metallic foil and the metal or high thermal conductive ceramic substrate; and
curing the curable resin composition.

**Amended claims under Art. 19.1 PCT**

**1.** (currently amended) A curable resin composition comprising:

aluminum nitride particles;
an epoxy resin;
a curing agent; and
an acidic phosphate ester represented by the following formula [[(1):]] (2):

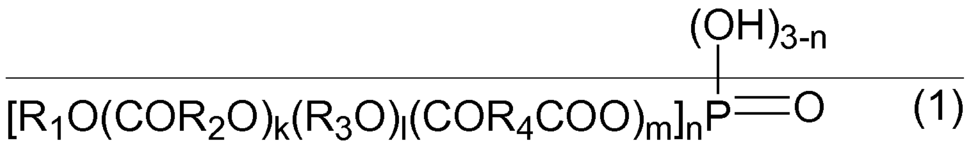

(1)

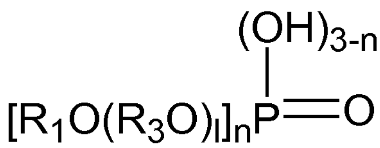

(2)

(In the formula [[(1),]] (2),

$R_1$ represents a saturated or unsaturated hydrocarbyl group having a carbon number of 4 to 20;
$R_3$ represents a saturated hydrocarbylene group having a carbon number of 2 or 3;
l represents an integer of 0 to 20; and
n represents an integer of 1 or 2, wherein
where a plurality of $R_1$ exist, the plurality of $R_1$ may be the same as or different from each other;
where a plurality of $R_3$ exist, the plurality of $R_3$ may be the same as or different from each other.),
wherein the aluminum nitride particles, the epoxy resin, the curing agent, and the acidic phosphate ester are mixed with each other in the curable resin composition.

**2.** (currently amended) A method for manufacturing a curable resin composition comprising the step of:

mixing aluminum nitride particles, an epoxy resin, a curing agent, and an acidic phosphate ester represented by the following formula [[(1)]] (2) with each other:

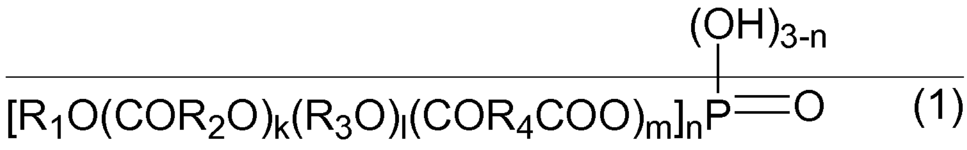 (1)

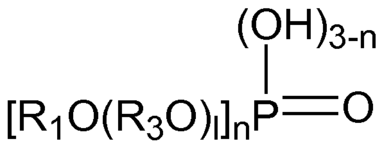 (2)

(In the formula [[(1),]] (2),

$R_1$ represents a saturated or unsaturated hydrocarbyl group having a carbon number of 4 to 20;
$R_3$ represents a saturated hydrocarbylene group having a carbon number of 2 or 3;
l represents an integer of 0 to 20; and
n represents an integer of 1 or 2, wherein
where a plurality of $R_1$ exist, the plurality of $R_1$ may be the same as or different from each other;
where a plurality of $R_3$ exist, the plurality of $R_3$ may be the same as or different from each other.).

**3.** (original) The method for manufacturing the curable resin composition according to claim 2, wherein the mixing step comprises the step of:

mixing the aluminum nitride particles with a mixture containing the acidic phosphate ester and all or a portion of the epoxy resin.

**4.** (original) The method for manufacturing the curable resin composition according to claim 2 or 3, wherein the mixing step comprises the successive steps of:

(i) mixing the acidic phosphate ester and the epoxy resin; and
(ii) mixing the resultant mixture of the step (i), the aluminum nitride particles, and the curing agent.

**5.** (original) The method for manufacturing the curable resin composition according to claim 2 or 3, wherein the mixing step comprises the successive steps of:

(i) mixing the acidic phosphate ester and a portion of the epoxy resin;
(ii) mixing the resultant mixture of the step (i) and the aluminum nitride particles; and
(iii) mixing the resultant mixture of the step (ii), the remaining portion of the epoxy resin, and the curing agent, and wherein the curing agent is a basic curing agent.

**6.** (original) A high thermal conductive resin composition, which is obtainable by curing the curable resin composition according to claim 1.

**7.** (original) A high thermal conductive laminated substrate comprising:

a metallic foil;
the high thermal conductive resin composition according to claim 6; and
a metal or high thermal conductive ceramic substrate,
wherein the metallic foil, the high thermal conductive resin composition according to claim 6, and the metal or high thermal conductive ceramic substrate, are layered in the order mentioned.

**8.** (original) A method for manufacturing a high thermal conductive laminated substrate comprising the successive

steps of:

layering a metallic foil and a metal or high thermal conductive ceramic substrate, wherein the curable resin composition according to claim 1 is disposed between the metallic foil and the metal or high thermal conductive ceramic substrate; and
curing the curable resin composition.

Fig. 1

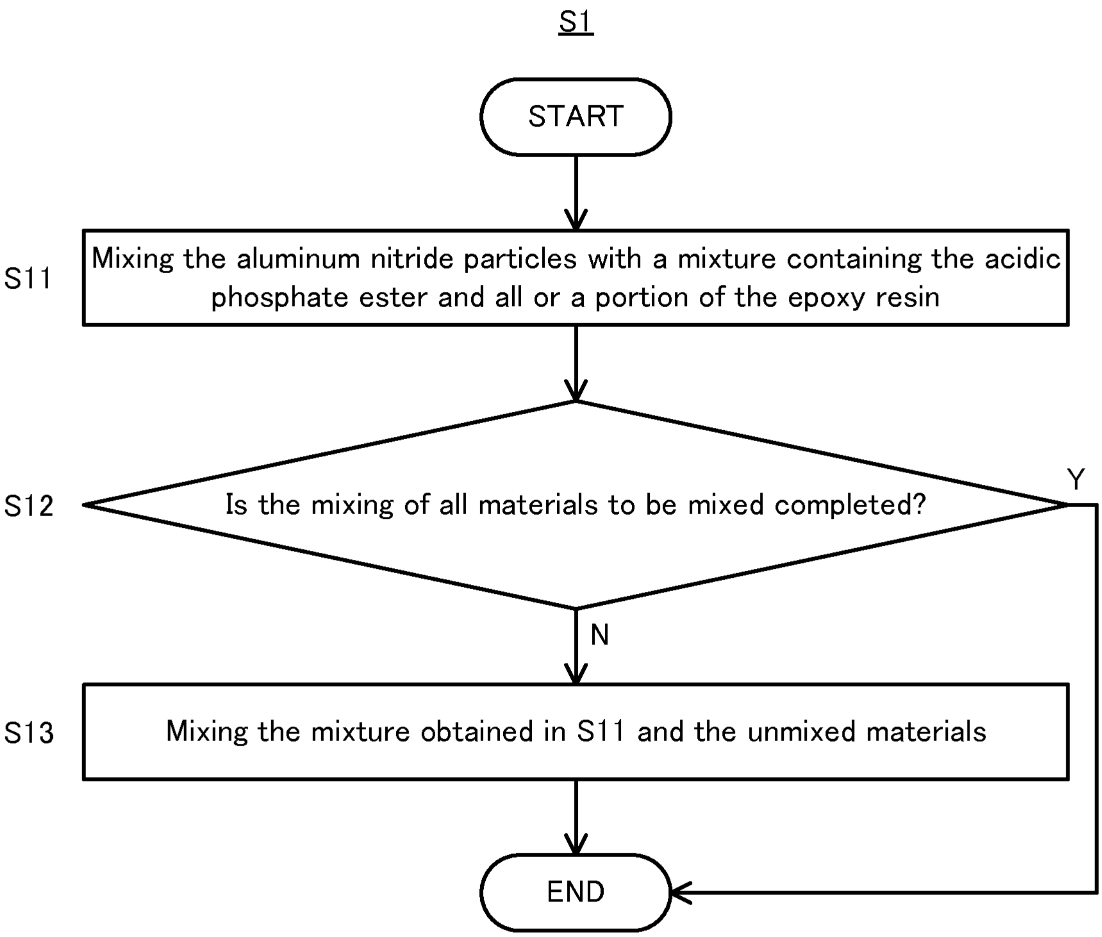
S1
START
S11
Mixing the aluminum nitride particles with a mixture containing the acidic phosphate ester and all or a portion of the epoxy resin
S12
Is the mixing of all materials to be mixed completed?
Y
N
S13
Mixing the mixture obtained in S11 and the unmixed materials
END

Fig. 2

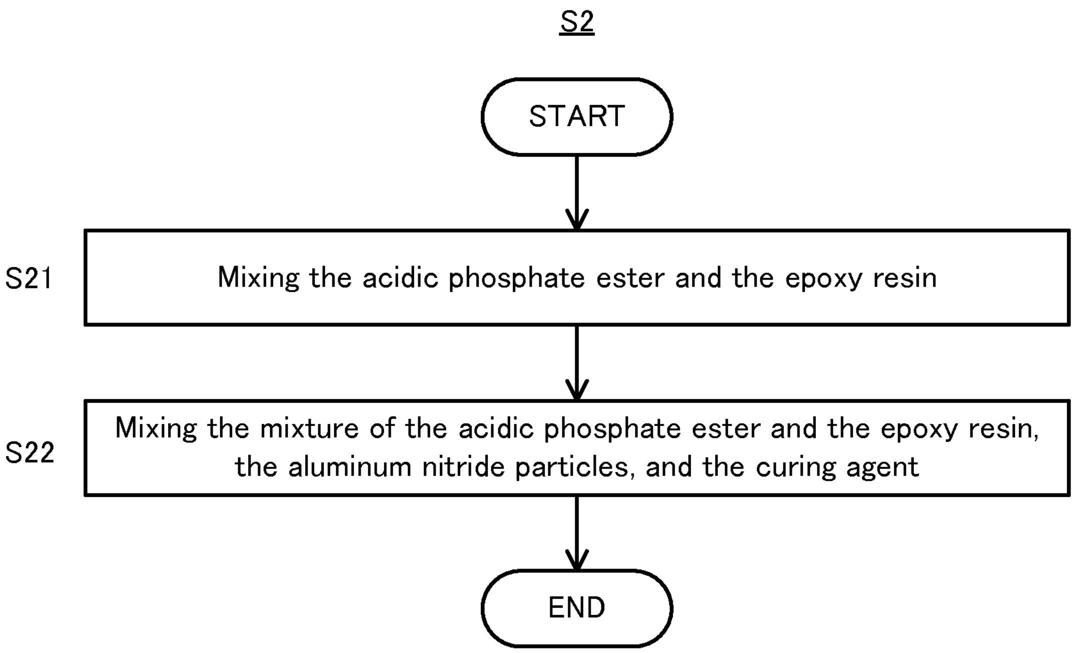
S2
START
S21
Mixing the acidic phosphate ester and the epoxy resin
S22
Mixing the mixture of the acidic phosphate ester and the epoxy resin, the aluminum nitride particles, and the curing agent
END

Fig. 3

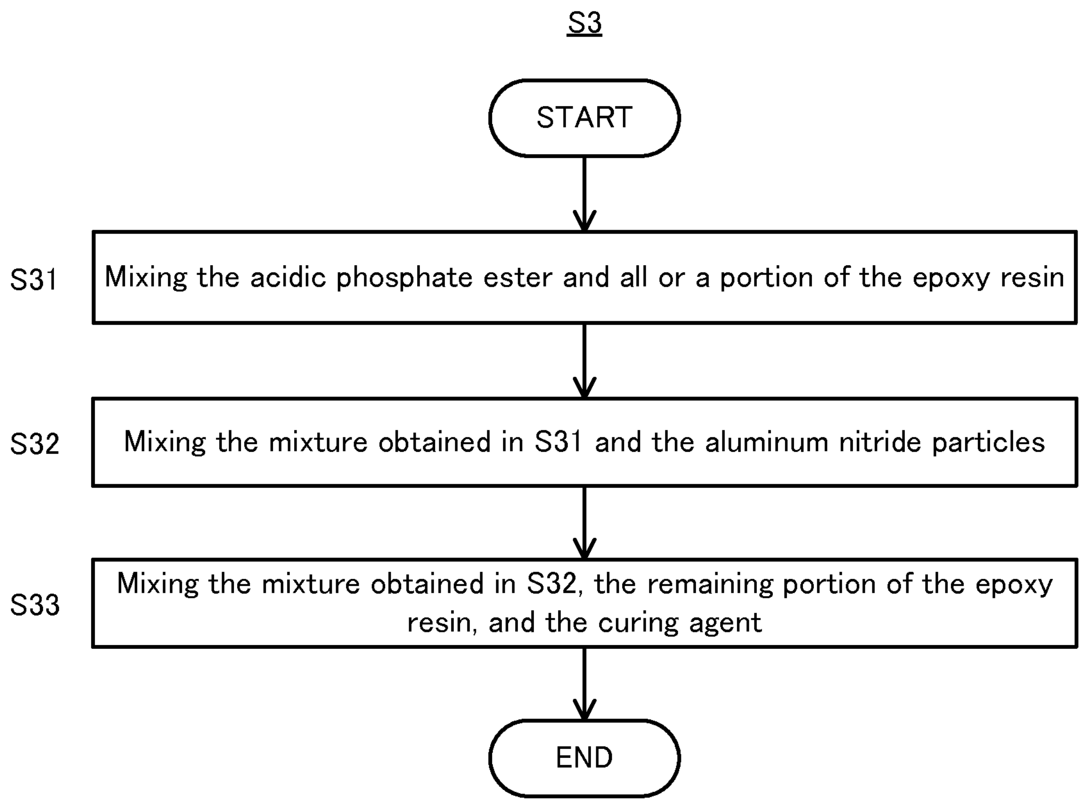
S3
START
S31
Mixing the acidic phosphate ester and all or a portion of the epoxy resin
S32
Mixing the mixture obtained in S31 and the aluminum nitride particles
S33
Mixing the mixture obtained in S32, the remaining portion of the epoxy resin, and the curing agent
END

Fig. 4

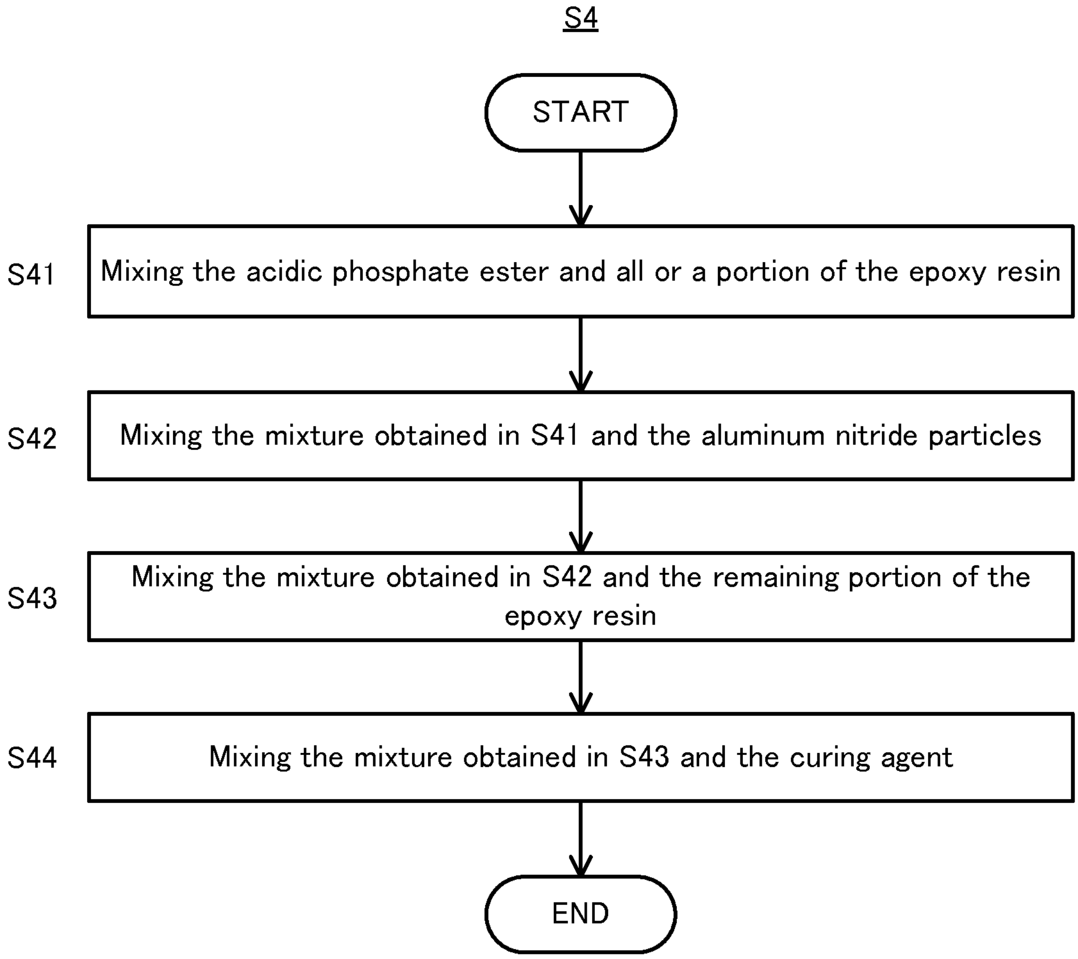
S4
START
S41
Mixing the acidic phosphate ester and all or a portion of the epoxy resin
S42
Mixing the mixture obtained in S41 and the aluminum nitride particles
S43
Mixing the mixture obtained in S42 and the remaining portion of the epoxy resin
S44
Mixing the mixture obtained in S43 and the curing agent
END

Fig. 5

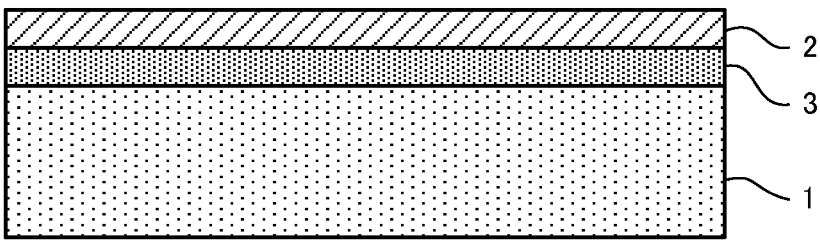

Fig. 6

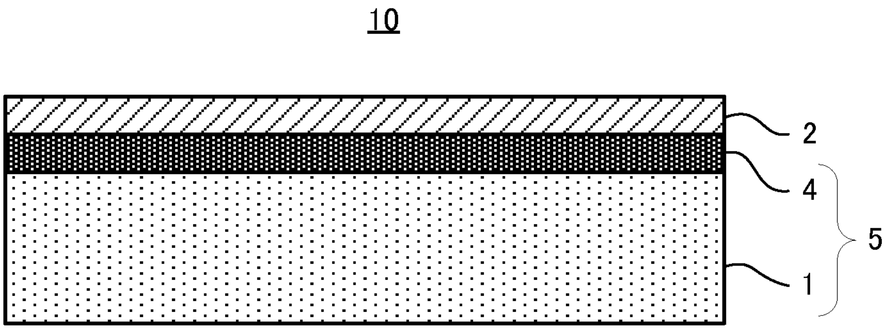

Fig. 7

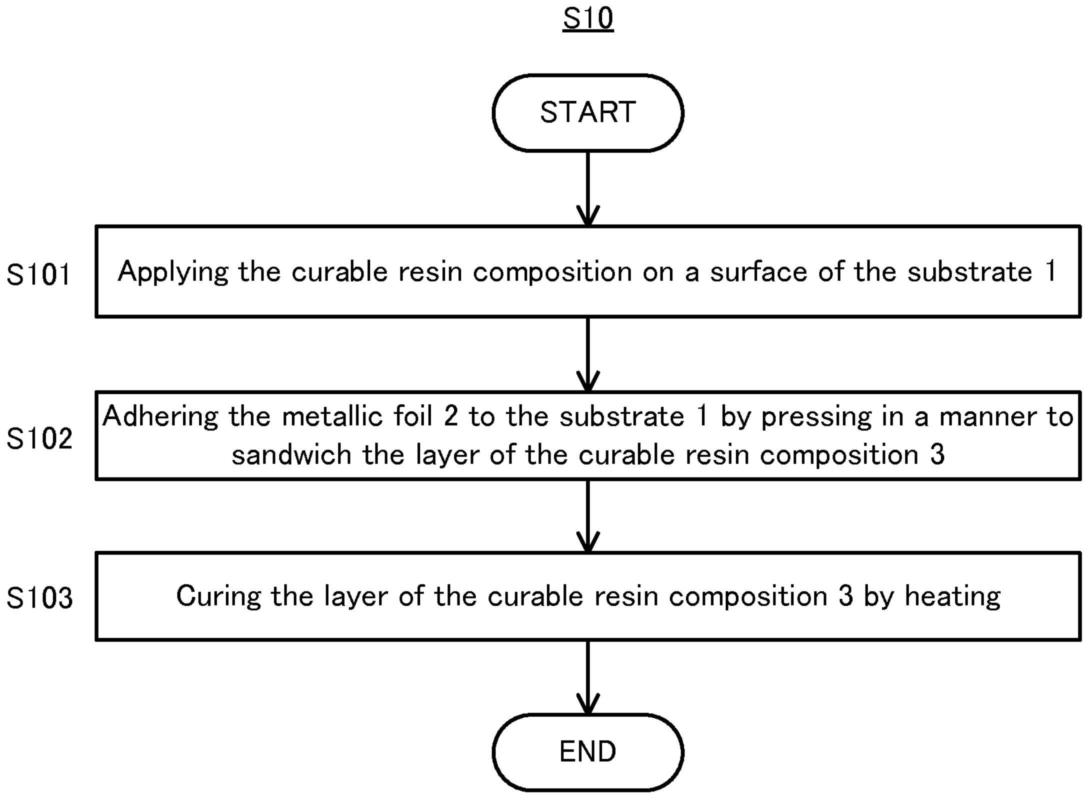
S10
START
S101
Applying the curable resin composition on a surface of the substrate 1
S102
Adhering the metallic foil 2 to the substrate 1 by pressing in a manner to sandwich the layer of the curable resin composition 3
S103
Curing the layer of the curable resin composition 3 by heating
END

Fig. 8

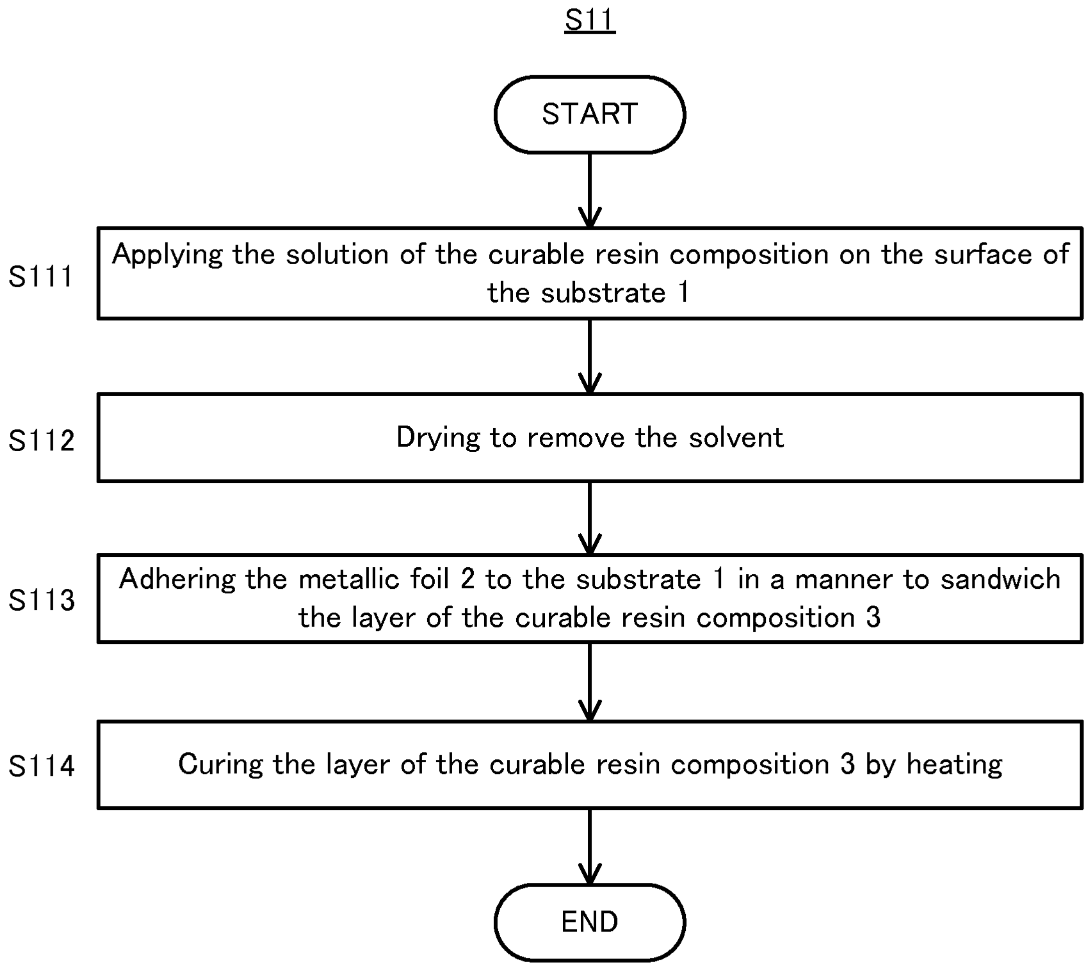
S11
START
S111
Applying the solution of the curable resin composition on the surface of the substrate 1
S112
Drying to remove the solvent
S113
Adhering the metallic foil 2 to the substrate 1 in a manner to sandwich the layer of the curable resin composition 3
S114
Curing the layer of the curable resin composition 3 by heating
END

Fig. 9

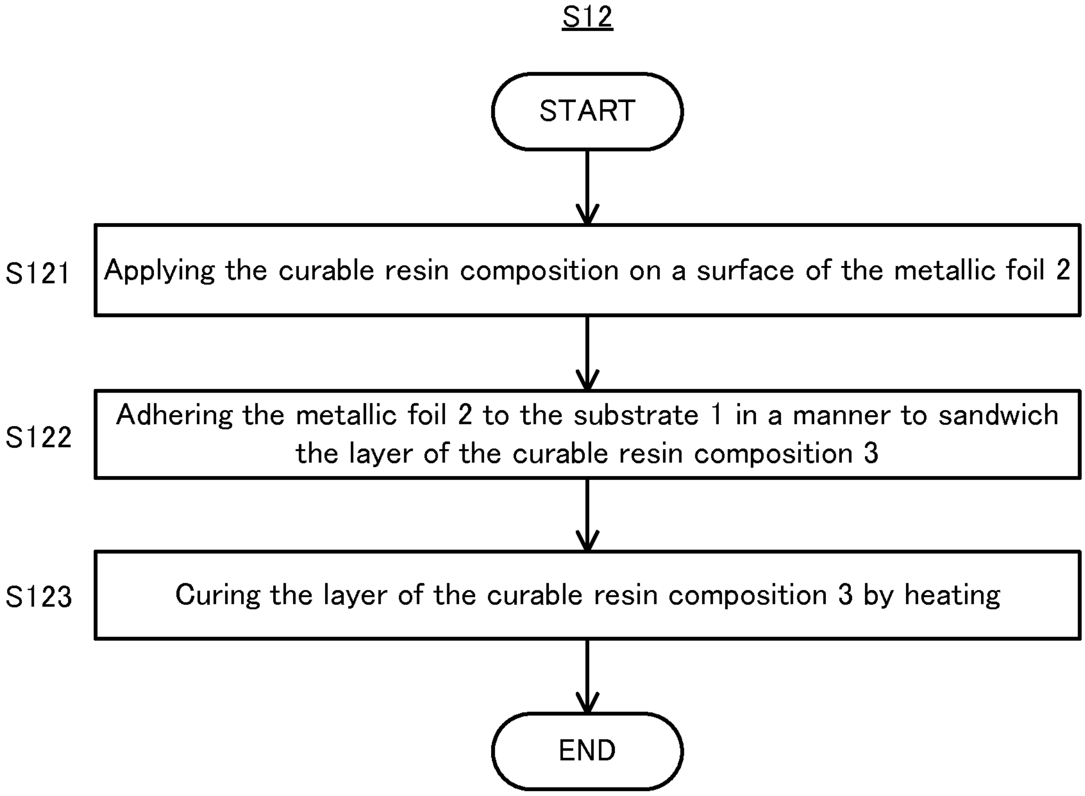
S12
START
S121
Applying the curable resin composition on a surface of the metallic foil 2
S122
Adhering the metallic foil 2 to the substrate 1 in a manner to sandwich the layer of the curable resin composition 3
S123
Curing the layer of the curable resin composition 3 by heating
END

Fig. 10

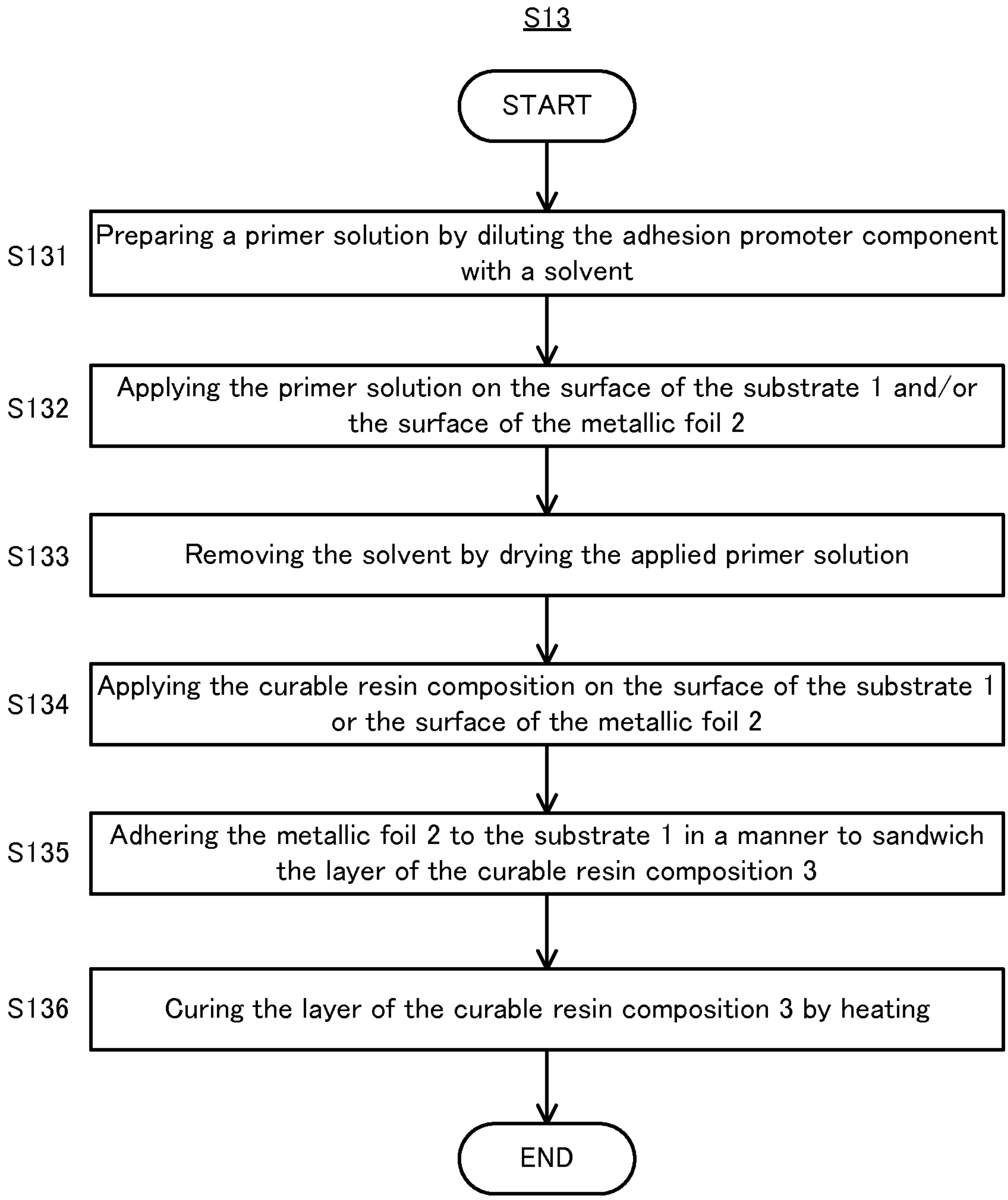
S13
START
S131
Preparing a primer solution by diluting the adhesion promoter component with a solvent
S132
Applying the primer solution on the surface of the substrate 1 and/or the surface of the metallic foil 2
S133
Removing the solvent by drying the applied primer solution
S134
Applying the curable resin composition on the surface of the substrate 1 or the surface of the metallic foil 2
S135
Adhering the metallic foil 2 to the substrate 1 in a manner to sandwich the layer of the curable resin composition 3
S136
Curing the layer of the curable resin composition 3 by heating
END

## INTERNATIONAL SEARCH REPORT

International application No.
PCT/JP2013/059384

A. CLASSIFICATION OF SUBJECT MATTER
*C08L63/00*(2006.01)i, *C08K3/28*(2006.01)i, *C08K5/52*(2006.01)i, *H01L23/12*(2006.01)i, *H01L23/36*(2006.01)i

According to International Patent Classification (IPC) or to both national classification and IPC

B. FIELDS SEARCHED

Minimum documentation searched (classification system followed by classification symbols)
C08L63/00-63/10, C08K3/00-13/08, H01L23/12, H01L23/34-23/46

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2013 |
| Kokai Jitsuyo Shinan Koho | 1971-2013 | Toroku Jitsuyo Shinan Koho | 1994-2013 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | JP 2004-75817 A (Denki Kagaku Kogyo Kabushiki Kaisha), 11 March 2004 (11.03.2004), claims; paragraphs [0007], [0013], [0025] to [0029]; examples (Family: none) | 1-8 |
| Y | JP 2002-322372 A (Denki Kagaku Kogyo Kabushiki Kaisha), 08 November 2002 (08.11.2002), claims; paragraphs [0007], [0013], [0019] (Family: none) | 1-8 |
| Y | JP 2005-320479 A (KYOCERA Chemical Corp.), 17 November 2005 (17.11.2005), claims; paragraphs [0002], [0006], [0017] (Family: none) | 1-8 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 21 June, 2013 (21.06.13) | 02 July, 2013 (02.07.13) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

International application No.
PCT/JP2013/059384

C (Continuation). DOCUMENTS CONSIDERED TO BE RELEVANT

| Category* | Citation of document, with indication, where appropriate, of the relevant passages | Relevant to claim No. |
|---|---|---|
| Y | JP 7-101762 A (Takemoto Oil & Fat Co., Ltd.), 18 April 1995 (18.04.1995), claims; paragraphs [0003] to [0005], [0019] (Family: none) | 1-8 |
| Y | JP 10-330626 A (Teijin Seiki Co., Ltd.), 15 December 1998 (15.12.1998), claims; paragraphs [0019], [0033] to [0035], [0037], [0041] (Family: none) | 1-3,6-8 |
| A | JP 6-172618 A (Denki Kagaku Kogyo Kabushiki Kaisha), 21 June 1994 (21.06.1994), paragraph [0005] (Family: none) | 1-8 |
| A | JP 10-306201 A (Toray Industries, Inc.), 17 November 1998 (17.11.1998), claims (Family: none) | 1-8 |
| A | JP 2009-167261 A (Meidensha Corp.), 30 July 2009 (30.07.2009), claims; paragraph [0027] (Family: none) | 1-8 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP H09181423 B
- JP H10284813 B
- JP 2006098454 A
- JP 2005320479 A
- JP H10173097 B